# EUROPÄISCHE PATENTSCHRIFT

(11) **EP 1 025 646 B1**
(45) Veröffentlichungstag und Bekanntmachung des Hinweises auf die Patenterteilung: **26.09.2001**
(21) Anmeldenummer: 98940163.3
(22) Anmeldetag: 07.07.1998
(51) Int. Cl.: H03M 7/00

(54) **VERFAHREN UND VORRICHTUNG ZUM CODIEREN VON AUDIOSIGNALEN SOWIE VERFAHREN UND VORRICHTUNGEN ZUM DECODIEREN EINES BITSTROMS**
METHODS AND DEVICES FOR ENCODING AUDIO SIGNALS AND METHODS AND DEVICES FOR DECODING A BIT STREAM
PROCEDE ET DISPOSITIF DE CODAGE DE SIGNAUX AUDIO AINSI QUE PROCEDE ET DISPOSITIF DE DECODAGE D'UN TRAIN DE BITS

(30) Priorität: 24.10.1997 DE 19747132
(43) Veröffentlichungstag der Anmeldung: 09.08.2000
(73) Patentinhaber: FRAUNHOFER-GESELLSCHAFT ZUR FÖRDERUNG DER ANGEWANDTEN FORSCHUNG E.V., 80636 München (DE)
(72) Erfinder: GRILL, Bernhard, D-91207 Lauf (DE); HERRE, Jürgen, D-91054 Buckenhof (DE); TEICHMANN, Bodo, D-90427 Nürnberg (DE); BRANDENBURG, Karlheinz, D-91054 Erlangen (DE); GERHÄUSER, Heinz, D-91344 Waischenfeld (DE)
(74) Vertreter: Schoppe, Fritz, Dipl.-Ing.
(86) Internationale Anmeldenummer: EP9804200
(87) Internationale Veröffentlichungsnummer: WO9922451

(56) Entgegenhaltungen:
- DE-C- 19 537 338
- HERRE J; JOHNSTON J D: "Enhancing the Performance of Perceptual Audio Coders by Using Temporal Noise Shaping (TNS)" 101ST AES CONVENTION, LOS ANGELES, CA, USA, PREPRINT 4384, 8. - 11. November 1996, XP002102636 in der Anmeldung erwähnt
- GRILL B ET AL: "A TWO- OR THREE-STAGE BIT RATE SCALABLE AUDIO CODING SYSTEM" AMERICAN ENGINEERING SOCIETY CONVENTION, 6. Oktober 1995, Seiten 1-8, XP000613371

## Beschreibung

Die vorliegende Erfindung bezieht sich auf skalierbare Audiocodierer und Audiodecodierer und insbesondere auf skalierbare Codierer bzw. Decodierer, bei denen zumindest eine Stufe im Frequenzbereich arbeitet.

Skalierbare Audiocoder sind Coder, die modular aufgebaut sind. So besteht die Bestrebung, bereits bestehende Sprachcodierer zu verwenden, die Signale, die z. B. mit 8 kHz abgetastet sind, verarbeiten und Datenraten von beispielsweise 4,8 bis 8 Kilobit pro Sekunde ausgeben. Diese bekannten Codierer, wie z. B. die für Fachleute bekannten Codierer G. 729, G.723, FS1016, CELP oder parametrische Modelle für MPEG-4-Audio, dienen hauptsächlich zum Codieren von Sprachsignalen und sind im allgemeinen zum Codieren von höherqualitativen Musiksignalen nicht geeignet, da sie üblicherweise für mit 8 kHz abgetastete Signale entworfen sind, weshalb sie lediglich eine Audiobandbreite von maximal 4 kHz codieren können. Sie zeigen jedoch im allgemeinen eine niedrige Abtastrate und eine gute Qualität für Sprachsignale.

Zur Audiocodierung von Musiksignalen, um beispielsweise HIFI-Qualität oder CD-Qualität zu erreichen, wird daher bei einem skalierbaren Codierer ein Sprachcodierer mit einem Audiocodierer kombiniert, der Signale mit höherer Abtastrate, wie z. B. 48 kHz, codieren kann. Selbstverständlich ist es auch möglich, den oben genannten Sprachcodierer durch einen anderen Codierer zu ersetzen, beispielsweise durch einen Musik/Audiocodierer nach den Standards MPEG1, MPEG2 oder MPEG4.

Eine derartige Kettenschaltung besteht aus einem Sprachcodierer und einem höherwertigen Audiocodierer. Ein Eingangssignal, das beispielsweise eine Abtastrate von 48 kHz aufweist, wird mittels eines Downsampling-Filters auf die für den Sprachcodierer geeignete Abtastfrequenz umgesetzt. Die Abtastrate könnte jedoch auch in beiden Codierern die gleiche sein. Nun wird das umgesetzte Signal codiert. Das codierte Signal kann direkt einer Bitstromformatiereinrichtung zugeführt werden, um übertragen zu werden. Es enthält jedoch lediglich Signale mit einer Bandbreite von z. B. maximal 4 kHz. Das codierte Signal wird ferner wieder decodiert und mittels eines Upsampling-Filters umgesetzt. Das nun erhaltene Signal besitzt jedoch aufgrund des Downsampling-Filters lediglich Nutzinformationen mit einer Bandbreite von beispielsweise 4 kHz. Ferner ist festzustellen, daß der Spektralgehalt des umgesetzten codierten/decodierten Signals im unteren Band bis 4 kHz nicht exakt dem ersten 4-kHz-Band des mit 48 kHz abgetasteten Eingangssignals entspricht, da Codierer im allgemeinen Codierfehler einführen.

Wie bereits erwähnt wurde, weist ein skalierbarer Codierer oder Coder sowohl einen allgemein bekannten Sprachcodierer als auch einen Audiocodierer auf, der Signale mit höheren Abtastraten verarbeiten kann. Um Signalanteile des Eingangssignals übertragen zu können, deren Frequenzen über 4 kHz sind, wird eine Differenz des Eingangssignals mit 8 kHz und des codierten/decodierten, umgesetzten Ausgangssignals des Sprachcodierers für jeden einzelnen zeitdiskreten Abtastwert gebildet. Diese Differenz kann dann mittels eines bekannten Audiocodierers quantisiert und codiert werden, wie es für Fachleute bekannt ist. An dieser Stelle sei angemerkt, daß das Differenzsignal, das in den Audiocodierer, der Signale mit höheren Abtastraten codieren kann, eingespeist wird, im unteren Frequenzbereich abgesehen von Codierfehlern des Sprachcodierers im wesentlichen Null ist. In dem Spektralbereich, der oberhalb der Bandbreite des nach oben umgesetzten codierten/decodierten Ausgangssignals des Sprachcodierers liegt, entspricht das Differenzsignal im wesentlichen dem wahren Eingangssignal bei 48 kHz.

In der ersten Stufe, d.h. der Stufe des Sprachcodierers, wird also zumeist ein Coder mit niedriger Abtastfrequenz eingesetzt, da im allgemeinen eine sehr niedrige Bitrate des codierten Signals angestrebt wird. Derzeit arbeiten mehrere Coder, auch die genannten Coder, mit Bitraten von wenigen Kilobit (zwei bis 8 Kilobit oder auch darüber). Dieselben ermöglichen ferner eine maximale Abtastfrequenz von 8 kHz, da ohnehin nicht mehr Audiobandbreite bei dieser geringen Bitrate möglich ist, und die Codierung bei niedriger Abtastfrequenz bezüglich des Rechenaufwands günstiger ist. Die maximal mögliche Audiobandbreite beträgt 4 kHz und ist in der Praxis auf etwa 3,5 kHz beschränkt. Soll jetzt in der weiteren Stufe, d.h. in der Stufe mit dem Audiocoder, eine Bandbreitenverbesserung erzielt werden, muß diese weitere Stufe mit einer höheren Abtastfrequenz arbeiten.

Seit einiger Zeit ist es bekannt, zur weiteren Reduzierung der Datenmenge die sog. TNS-Technik bei der hochqualitativen Audiocodierung einzusetzen (J. Herre, J. D. Johnston, "Enhancing the Performance of Perceptual Audio Coders by Using Temporal Noise Shaping (TNS)", 101st AES Convention, Los Angeles 1996, Preprint 4384). Die TNS-Technik (TNS = Temporal Noise Shaping = zeitliche Rauschformung) gestattet allgemein gesagt mittels einer prädiktiven Codierung der Spektralwerte eine zeitliche Formung der Feinstruktur des Quantisierungsrauschens. Die TNS-Technik basiert auf einer konsequenten Anwendung des Dualismus zwischen Zeit- und Frequenzbereich. Aus der Technik ist bekannt, daß die Autokorrelationsfunktion eines Zeitsignals, wenn sie in den Frequenzbereich transformiert wird, die spektrale Leistungsdichte eben diesen Zeitsignals angibt. Der duale Fall dazu ergibt sich, wenn die Autokorrelationsfunktion des Spektrums eines Signals gebildet wird und in den Zeitbereich transformiert wird. Die in den Zeitbereich transformierte oder rücktransformierte Autokorrelationsfunktion wird auch als Quadrat der Hilbert-Hüllkurve des Zeitsignals bezeichnet. Die Hilbert-Hüllkurve eines Signals ist somit direkt mit der Autokorrelationsfunktion seines Spektrums verbunden. Die quadrierte Hilbert-Hüllkurve eines Signals und die spektrale Leistungsdichte desselben stellen somit duale Aspekte im Zeitbereich und im Frequenzbereich dar. Wenn die Hilbert-Hüllkurve eines Signals für jedes Teilbandpaßsignal über einem Bereich von Frequenzen konstant bleibt, dann wird auch die Autokorrelation zwischen benachbarten Spektralwerten konstant sein. Dies bedeutet in der Tat, daß die Serie von Spektralkoeffizienten über der Frequenz stationär ist, weshalb prädiktive Codiertechniken effizient verwendet werden können, um dieses Signal darzustellen, und zwar unter Verwendung eines gemeinsamen Satzes von Prädiktionskoeffizienten.

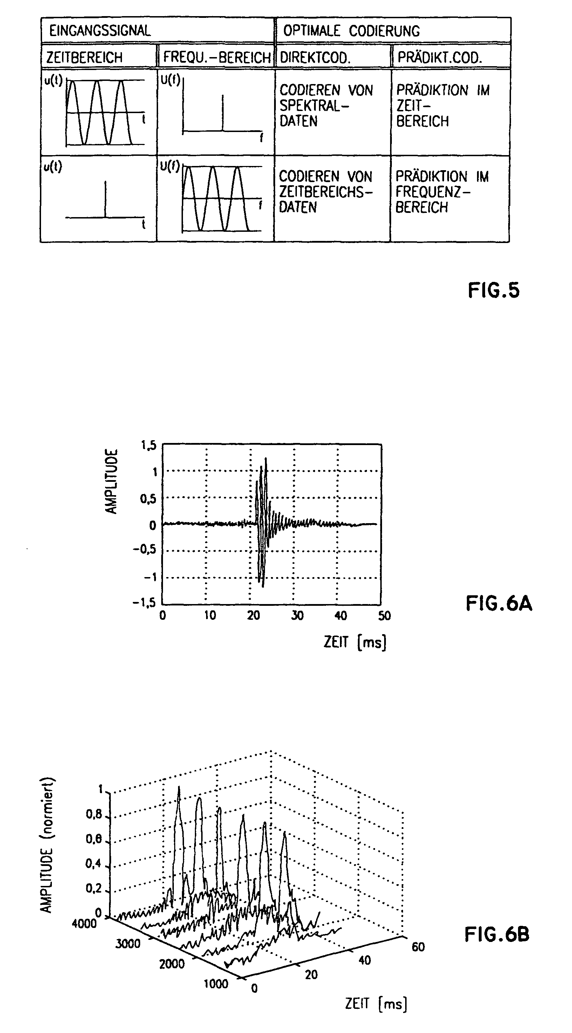

Um diesen Sachverhalt zu veranschaulichen, sei auf die Fig. 6A und Fig. 6B verwiesen. Fig. 6A zeigt einen kurzen Ausschnitt aus einem zeitlich stark transienten "Kastagnetten"-Signal einer Dauer von ca. 40 ms. Dieses Signal wurde in mehrere Teilbandpaßsignale zerlegt, wobei jedes Teilbandpaßsignal eine Bandbreite von 500 Hz hat. Fig. 6B zeigt nun die Hilbert-Hüllkurven für diese Bandpaßsignale mit Mittenfrequenzen, die von 1500 Hz bis 4000 Hz reichen. Aus Klarheitsgründen wurden alle Hüllkurven auf ihre Maximalamplitude normiert. Offensichtlich sind die Formen aller Teilhüllkurven sehr stark aufeinander bezogen, weshalb ein gemeinsamer Prädiktor innerhalb dieses Frequenzbereiches verwendet werden kann, um das Signal effizient zu codieren. Ähnliche Beobachtungen können bei Sprachsignalen gemacht werden, bei denen der Effekt der glottalen Erregungspulse über dem gesamten Frequenzbereich aufgrund der Natur des menschlichen Spracherzeugungsmechanismus vorhanden ist.

Fig. 6B zeigt also, daß die Korrelation benachbarter Werte beispielsweise bei einer Frequenz von 2000 Hz ähnlich wie bei beispielsweise einer Frequenz von 3000 Hz bzw. 1000 Hz ist.

Eine alternative Weise zum Verständnis der Eigenschaft der spektralen Prädiktierbarkeit von transienten Signalen kann aus der in Fig. 5 dargestellten Tabelle erhalten werden. Links oben in der Tabelle ist ein zeitkontinuierliches Signal u(t) gezeigt, das einen sinusförmigen Verlauf hat. Dem ist das Spektrum U(f) dieses Signales gegenübergestellt, das aus einem einzigen Dirac-Impuls besteht. Die optimale Codierung für dieses Signal besteht in der Codierung von Spektraldaten oder Spektralwerten, da hier für das gesamte Zeitsignal lediglich sowohl der Betrag als auch die Phase des Fourrierkoeffizienten übertragen werden braucht, um das Zeitsignal vollständig rekonstruieren zu können. Ein Codieren von Spektraldaten entspricht gleichzeitig einer Prädiktion im Zeitbereich. Eine prädiktive Codierung würde hier also im Zeitbereich stattfinden müssen. Das sinusförmige Zeitsignal hat also eine flache zeitliche Hüllkurve, welche einer maximal nicht flachen Hüllkurve im Frequenzbereich entspricht.

Nun sei der entgegengestzte Fall betrachtet, bei dem das Zeitsignal u(t) ein maximal transientes Signal in der Form eines Dirac-Impulses im Zeitbereich ist. Ein Dirac-Impuls im Zeitbereich entspricht einem "flachen" Leistungsspektrum, während das Phasenspektrum gemäß der zeitlichen Position des Impulses rotiert. Offensichtlich stellt dieses Signal für die oben erwähnten traditionellen Verfahren, wie z. B. die Transformationscodierung oder Codierung von Spektraldaten oder eine lineare Prädiktionscodierung der Zeitbereichsdaten, ein Problem dar. Dieses Signal kann am besten und effektivsten im Zeitbereich codiert werden, da lediglich die zeitliche Position sowie die Leistung des Dirac-Impulses übertragen werden muß, was durch konsequente Anwendung des Dualismus dazu führt, daß auch eine prädiktive Codierung im Frequenzbereich eine geeignetes Verfahren zur effizienten Codierung darstellt.

Es ist sehr wichtig, nicht die prädiktive Codierung von Spektralkoeffizienten über der Frequenz mit dem bekannten dualen Konzept der Prädiktion von Spektralkoeffizienten von einem Block zum nächsten zu verwechseln, das bereits implementiert ist und ebenfalls in dem oben erwähnten Artikel (M. Bosi, K. Brandenburg, S. Quakenbush, L. Fielder, K. Akagiri, H. Fuchs, M. Dietz, J. Herre, G. Davidson, Yoshiaki Oikawa: "ISO/IEC MPEG-2 Advanced Audio Coding", 101st AES Convention, Los Angeles 1996, Preprint 4382) beschrieben ist. Bei der Prädiktion von Spektralkoeffizienten von einem Block zum nächsten, welche einer Prädiktion über der Zeit entspricht, wird die spektrale Auflösung erhöht, während eine Prädiktion von Spektralwerten über der Frequenz die zeitliche Auflösung steigert. Ein Spektralkoeffizient bei beispielsweise 1000 Hz kann also durch den Spektralkoeffizienten bei beispielsweise 900 Hz in demselben Block oder Frame ermittelt werden.

Die dargestellten Überlegungen führten also dazu, ein effizientes Codierverfahren für transiente Signale zu erhalten. Prädiktive Codiertechniken können unter Berücksichtigung der Dualität zwischen Zeit und Frequenzbereich im wesentlichen analog zu der bereits bekannten Prädiktion von einem Spektralkoeffizienten zum Spektralkoeffizienten mit gleicher Frequenz im nächsten Block behandelt werden. Da die spektrale Leistungsdichte und die quadrierte Hilbert-Hüllkurve eines Signals dual zueinander sind, wird eine Reduktion einer Restsignalenergie oder ein Prädiktionsgewinn abhängig von einem Flachheitsmaß der quadrierten Hüllkurve des Signals im Gegensatz zu einem spektralen Flachheitsmaß beim konventionellen Prädiktionsverfahren erhalten. Der potentielle Codierungsgewinn steigt mit transienteren Signalen an.

Als mögliche Prädiktionsschemen bietet sich sowohl das Prädiktionsschema mit geschlossener Schleife, das auch Rückwärtsprädiktion genannt wird, sowie das Prädiktionsschema mit offener Schleife, das auch Vorwärtsprädiktion genannt wird, an. Beim spektralen Prädiktionsschema mit geschlossener Schleife (Rückwärtsprädiktion) ist die Hüllkurve des Fehlers flach. Anders ausgedrückt wird die Fehlersignalenergie gleichmäßig über der Zeit verteilt.

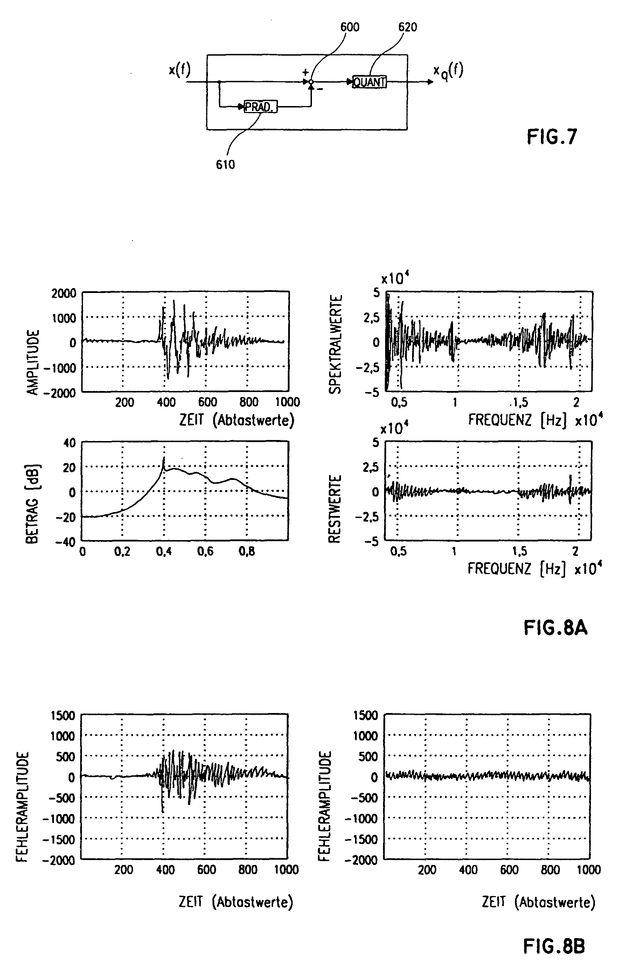

Bei einer Vorwärtsprädiktion, wie sie in Fig. 7 dargestellt ist, tritt jedoch eine zeitliche Formung des durch die Quantisierung eingeführten Rauschens auf. Ein zu prädizierender Spektralkoeffizient x(f) wird einem Summationspunkt 600 zugeführt. Derselbe Spektralkoeffizient wird ferner einem Prädiktor 610 zugeführt, dessen Ausgangssignal mit negativem Vorzeichen ebenfalls dem Summationspunkt 600 zugeführt wird. Das Eingangssignal in einen Quantisierer 620 stellt somit die Differenz des Spektralwerts x(f) und des durch Prädiktion berechneten Spektralwerts xₚ(f) dar. Bei der Vorwärtsprädiktion wird die Gesamtfehlerenergie in den decodierten Spektralkoeffizientendaten gleichbleiben. Die zeitliche Form des Quantisierungsfehlersignals wird jedoch als zeitlich geformt am Ausgang des Decodierers erscheinen, da die Prädiktion auf die Spektralkoeffizienten angewendet wurde, wodurch das Quantisierungsrauschen zeitlich unter das tatsächliche Signal gelegt wird und somit maskiert werden kann. Auf diese Art und Weise werden Probleme der zeitlichen Maskierung z. B. bei transienten Signalen oder Sprachsignalen vermieden.

Dieser Typ der prädiktiven Codierung von Spektralwerten wird daher als die TNS- oder zeitliche Rauschformungstechnik bezeichnet. Zur Veranschaulichung dieser Technik sei auf Fig. 8A verwiesen. Links oben in Fig. 8A befindet sich ein Zeitverlauf eines stark transienten Zeitsignals. Dem Zeitverlauf ist der Ausschnitt eines DCT-Spektrums rechts oben in Fig. 8A gegenübergestellt. Die linke untere Darstellung von Fig. 8A zeigt die resultierende Frequenzantwort eines TNS-Synthesefilters, das durch die LPC-Operation berechnet wurde (LPC = Linear Prediction Coding). Es sein angemerkt, daß die (normierten) Frequenzkoordinaten in diesem Diagramm den Zeitkoordinaten aufgrund der Zeitbereichs- und Frequenzbereichsdualität entsprechen. Offensichtlich führt die LPC-Berechnung zu einem "Quellenmodell" des Eingangssignals, da die Frequenzantwort des LPC-berechneten Synthesefilters der Hüllkurve des stark transienten Zeitsignals ähnelt. In Fig. 8A rechts unten ist eine Darstellung der spektralen Restwerte, d. h. des Eingangssignals des Quantisierers 620 in Fig. 7, über der Frequenz gezeigt. Ein Vergleich zwischen den spektralen Restwerten nach der Prädiktion und den Spektralwerten bei direkter Zeit-Frequenz-Transformation zeigt, daß die spektralen Restwerte eine wesentlich geringere Energie als die ursprünglichen Spektralwerte aufweisen. Bei dem gezeigten Beispiel entspricht die Reduktion der Energie der spektralen Restwerte einem Gesamtprädiktionsgewinn von etwa 12 dB.

Zu der Bedeutung der linken unteren Darstellung in Fig. 8A sei folgendes angemerkt. Bei klassischer Anwendung der Prädiktion auf Zeitbereichssignale ist der Frequenzgang des Synthesefilters eine Annäherung des Betragssspektrums des Eingangssignals. Das Synthesefilter (re)generiert gewissermaßen die spektrale Gestalt des Signals aus einem Restsignal mit näherungsweise "weißem" Spektrum. Bei Anwendung der Prädiktion auf spektrale Signale, wie es bei der TNS-Technik der Fall ist, ist der Frequenzgang des Synthesefilters eine Annäherung der Hüllkurve des Eingangsfilters. Der Frequenzgang des Synthesefilters ist nicht die Fouriertransformierte der Impulsantwort, wie es im klassischen Fall gilt, sondern die inverse Fouriertransformierte. Das TNS-Synthesefilter (re)generiert sozusagen den Hüllkurvenverlauf des Signals aus einem Restsignal mit näherungsweise "weißer" (d. h. flacher) Hüllkurve. So zeigt die linke untere Abbildung von Fig. 8A also die durch das TNS-Synthesefilter modellierte Hüllkurve des Eingangssignals. Diese ist hier eine logarithmische Darstellung der Hüllkurven-Annäherung des im der darüberliegenden Abbildung geziegten Kastagnettensignals.

Anschließend wurde ein Codierungsrauschen in die spektralen Restwerte eingeführt, derart, daß in jedem Codierband mit einer Breite von beispielsweise 0,5 Bark ein Signal/Rauschen-Verhältnis von etwa 13 dB resultierte. Die aus der Einführung des Quantisierungsrauschen resultierenden Fehlersignale im Zeitbereich sind in Fig. 8B gezeigt. Die linke Darstellung in Fig. 8B zeigt das Fehlersignal aufgrund des Quantisierungsrauschens bei verwendeter TNS-Technik, während im rechten Diagramm die TNS-Technik aus Vergleichszwecken nicht verwendet wurde. Wie erwartet ist das Fehlersignal im linken Diagramm nicht gleichmäßig über den Block verteilt, sondern in dem Bereich konzentriert, in dem auch ein hoher Signalanteil vorhanden ist, welcher dieses Quantisierungsrauschen optimal verdecken wird. Im rechten Fall ist dagegen das eingeführte Quantisierungsrauschen gleichmäßig im Block, d. h. über der Zeit, verteilt, was dazu führt, daß im vorderen Bereich, in dem tatsächlich kein oder fast kein Signal ist, ebenfalls Rauschen vorhanden ist, das zu hören sein wird, während in dem Bereich, in dem hohe Signalanteile vorhanden sind, ein relativ kleines Rauschen vorhanden ist, durch das die Maskierungsmöglichkeiten des Signals nicht vollständig ausgenützt werden.

Im nachfolgenden wird ein einfacher, d. h. nicht skalierbarer, Audiocodierer beschrieben, der ein TNS-Filter aufweist.

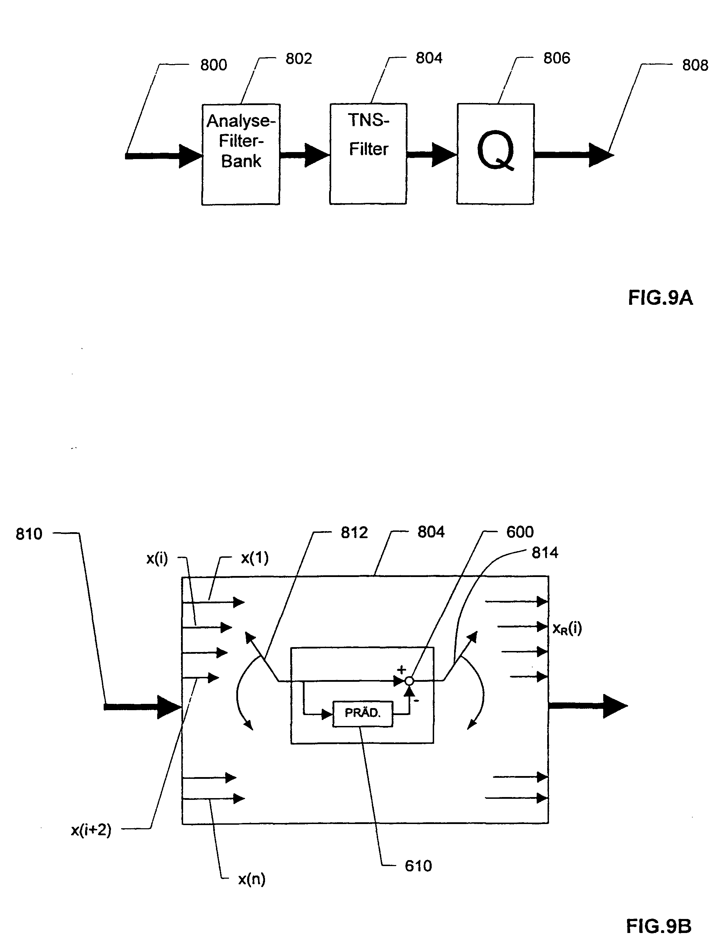

Eine Implementierung eines TNS-Filters 804 in einen Codierer ist in Fig. 9A gezeigt. Derselbe ist zwischen einer Analysefilterbank 802 und einem Quantisierer 806 angeordnet. Das zeitdiskrete Eingangssignal wird bei dem in Fig. 9A gezeigten Codierer in einen Audioeingang 800 eingespeist, während das quantisierte Audiosignal bzw. quantisierte Spektralwerte oder die quantisierten spektralen Restwerte an einem Ausgang 808 ausgegeben werden, dem ein Redundanz-Codierer nachgeschaltet sein kann. Das Eingangssignal wird also in Spektralwerte transformiert. Basierend auf den berechneten Spektralwerten wird eine übliche lineare Prädiktionsrechnung ausgeführt, welche beispielsweise durch Bilden der Autokorrelationsmatrix der Spektralwerte und unter Verwendung einer Levinson-Durbin-Rekursion stattfindet. Fig. 9B zeigt eine detailliertere Ansicht des TNS-Filters 804. An einem Filtereingang 810 werden die Spektralwerte x(1), ..., x(i), ..., x(n) eingespeist. Es kann vorkommen, daß lediglich ein bestimmter Frequenzbereich transiente Signale aufweist, während wiederum ein anderer Frequenzbereich eher stationärer Natur ist. Diese Tatsache wird bei dem TNS-Filter 804 durch einen Eingangsschalter 812 sowie durch einen Ausgangsschalter 814 berücksichtigt, wobei die Schalter zunächst jedoch für eine Parallel-zu-Seriell- bzw. Seriell-zu-Parallel-Wandlung der zu verarbeitenden Daten sorgen. Abhängig davon, ob ein bestimmter Frequenzbereich instationär ist und einen bestimmten Codierungsgewinn durch die TNS-Technik verspricht, wird nur dieser Spektralbereich TNS-verarbeitet, was dadurch geschieht, daß der Eingangsschalter 812 beispielsweise bei dem Spektralwert x(i) startet und z. B. bis zu dem Spektralwert x(i+2) läuft. Der innere Bereich des Filters besteht wieder aus der Vorwärtsprädiktionsstruktur, d. h. dem Prädiktor 610 sowie dem Summationspunkt 600.

Die Berechnung zur Bestimmung der Filterkoeffizienten des TNS-Filters bzw. zur Bestimmung der Prädiktionskoeffizienten wird folgendermaßen durchgeführt. Das Bilden der Autokorrelationsmatrix und das Verwenden der Levinson-Durbin-Rekursion wird für die höchste erlaubte Ordnung des Rauschformungsfilters, z. B. 20, durchgeführt. Wenn der berechnete Prädiktionsgewinn eine bestimmte Schwelle überschreitet, wird die TNS-Verarbeitung aktiviert.

Die Ordnung des verwendeten Rauschformungsfilters für den gegenwärtigen Block wird dann durch anschließendes Entfernen aller Koeffizienten mit einem ausreichend kleinen Absolutwert vom Ende des Koeffizientenarrays bestimmt. Auf diese Art und Weise liegen die Ordnungen von TNS-Filtern üblicherweise in der Größenordnung von 4 - 12 für ein Sprachsignal.

Wenn für einen Bereich von Spektralwerten x(i) beispielsweise ein ausreichend hoher Codierungsgewinn bestimmt wird, wird derselbe verarbeitet, und es wird am Ausgang des TNS-Filters nicht der Spektralwert x(i) sondern der spektrale Restwert X_{R} (i) ausgegeben. Dieser hat eine wesentlich geringere Amplitude als der ursprüngliche Spektralwert x(i), wie es aus Fig. 7a ersichtlich ist. Die zum Decodierer übertragenen Seiteninformationen erhalten somit zusätzlich zu den üblichen Seiteninformationen eine Flag, die die Verwendung von TNS anzeigt, und falls erforderlich, Informationen über den Zielfrequenzbereich und ebenfalls über das TNS-Filter, das zum Codieren verwendet wurde. Die Filterdaten können als quantisierte Filterkoeffizienten dargestellt werden.

In Analogie zum Codierer mit TNS-Filter sei nun auf einen Decodierer eingegangen, welcher ein inverses TNS-Filter aufweist.

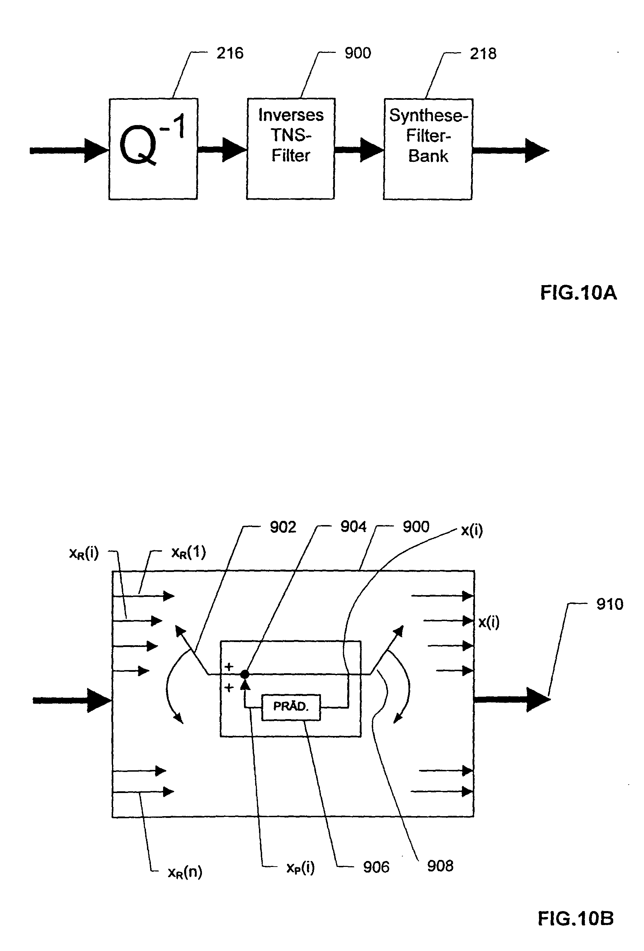

Im Decodierer, welcher in Fig. 10A skizziert ist, wird für jeden Kanal eine TNS-Codierung rückgängig gemacht. Spektrale Restwerte x_{R} (i) werden in dem inversen Quantisierer 216 requantisiert und in ein inverses TNS-Filter 900 eingespeist, dessen näherer Aufbau in Fig. 10B dargestellt ist. Das inverse TNS-Filter 900 liefert als Ausgangssignal wieder Spektralwerte, die in einer Synthesefilterbank 218 in den Zeitbereich transformiert werden. Das TNS-Filter 900 umfaßt wiederum einen Eingangsschalter 902 sowie einen Ausgangsschalter 908, welche zunächst wieder zur Parallel-Seriell-Wandlung bzw. zur Seriell-Paralalel-Wandlung der verarbeiteten Daten dienen. Der Eingangsschalter 902 berücksichtigt ferner einen eventuell verwendeten Zielfrequenzbereich, um nur spektrale Restwerte einer inversen TNS-Codierung zuzuführen, während nicht TNS-codierte Spektralwerte zu einem Ausgang 910 unverändert durchgelassen werden. Das inverse Prädiktionsfilter umfaßt wiederum einen Prädiktor 906 sowie einen Summationspunkt 904. Dieselben sind jedoch im Unterschied zum TNS-Filter folgendermaßen verbunden. Ein spektraler Restwert gelangt über den Eingangsschalter 902 an den Summationspunkt 904, an dem derselbe mit dem Ausgangssignal des Prädiktors 906 summiert wird. Der Prädiktor liefert als Ausgangssignal einen geschätzten Spektralwerts xₚ(i). Der Spektralwert x(i) wird über den Ausgangsschalter an den Ausgang des inversen TNS-Filters ausgegeben. Die TNS-bezogenen Seiteninformationen werden im Decodierer also decodiert, wobei die Seiteninformationen eine Flag umfassen, die die Verwendung von TNS anzeigt, und, falls erforderlich, Informationen bezüglich der Zielfrequenzbereichs. Zusätzlich enthalten die Seiteninformationen ferner die Filterkoeffizienten des Prädiktionsfilters, das zum Codieren eines Blocks oder "Frames" verwendet wurde.

Das TNS-Verfahren läßt sich also folgendermaßen zusammenfassen. Ein Eingangssignal wird in eine spektrale Darstellung mittels einer hochauflösenden Analysefilterbank transformiert. Anschließend wird eine lineare Prädiktion im Frequenzbereich ausgeführt, und zwar zwischen den frequenzmäßig benachbarten Spektralwerten. Diese lineare Prädiktion kann als Filterprozeß zum Filtern der Spektralwerte interpretiert werden, welcher im Spektralbereich ausgeführt wird. Damit werden die ursprünglichen Spektralwerte durch den Prädiktionsfehler, d. h. durch die spektralen Restwerte, ersetzt. Diese spektralen Restwerte werden ebenso wie übliche Spektralwerte quantisiert und codiert zum Decodierer übertragen, in dem die Werte wieder decodiert und invers quantisiert werden. Vor der Anwendung der inversen Filterbank (Synthesefilterbank) wird eine zur im Codierer vorgenommenen Prädiktion inverse Prädiktion vorgenommen, indem das inverse Prädiktionsfilter auf das übertragene Prädiktionsfehlersignal, d. h. auf die requantisierten spektralen Restwerte, angewendet wird.

Durch die Anwendung dieser Technik ist es möglich, die zeitliche Hüllkurve des Quantisierungsrauschens an die des Eingangssignals anzupassen. Dies erlaubt eine bessere Ausnutzung der Maskierung der Fehlersignale bei Signalen, die eine ausgeprägte Zeitfeinstruktur oder ein ausgeprägtes transientes Wesen haben. Im Falle von transienten Signalen vermeidet die TNS-Technik die sog. "Vorechos", bei denen das Quantisierungsgeräusch bereits vor dem "Anschlag" eines solchen Signals erscheint.

Bei einem skalierbaren Audiocodierer, wird, wie es bereits erwähnt wurde, in der ersten Stufe ein Codierer mit niedriger Abtastfrequenz eingesetzt, da im allgemeinen eine sehr niedrige Bitrate des codierten Signals angestrebt wird. In der zweiten Stufe findet sich dann vorzugsweise ein Audiocodierer, der zwar bei höheren Bitraten codiert, jedoch eine wesentlich größere Bandbreite benötigt und somit Audiosignale mit viel höhere Klangqualität codieren kann als der Sprachcodierer. Üblicherweise wird ein zu codierendes Audiosignal, das in einer hohen Abtastrate vorliegt, zuerst auf eine niedrige Abtastrate beispielsweise mittels eines Downsampling-Filters heruntergesetzt. Das in der Abtastrate reduzierte Signal wird dann in den Codierer der ersten Stufe eingespeist, wobei das Ausgangssignal dieses Codierers direkt in den Bitstrom geschrieben wird, der den skalierbaren Audiocodierer verläßt. Dieses codierte Signal mit niedriger Bandbreite wird wieder decodiert und dann beispielsweise mittels eines Upsampling-Filters wieder auf die hohe Abtastrate gebracht und dann in den Frequenzbereich transformiert. Ebenfalls in den Frequenzbereich transformiert wird das ursprüngliche am Eingang des Codierers anliegende Audiosignal. Es liegen nun zwei Audiosignale vor, wobei jedoch das erstere mit den Codierfehlern des Codierers der ersten Stufe versehen ist. Diese beiden Signale im Frequenzbereich können dann einem Differenzglied zugeführt werden, um ein Signal zu erhalten, das nur noch die Differenz beider Signale darstellt. In einem Schaltmodul, das auch als frequenzselektiver Schalter ausgeführt sein kann, wie es weiter hinten beschrieben wird, kann bestimmt werden, ob es günstiger ist, die Differenz der beiden Eingangssignale oder aber das ursprüngliche in den Frequenzbereich transformierte Audiosignal direkt weiter zu verarbeiten. Das Ausgangssignal des Schaltmoduls wird jedenfalls beispielsweise einem bekannten Quantisierer/Codierer zugeführt, welcher, wenn er nach einem MPEG-Standard arbeitet, zum einen eine Quantisierung unter Berücksichtigung eines psychoakustischen Modells durchführt, und zum anderen anschließend eine Entropie-Codierung vorzugsweise unter Verwendung der Huffman-Codierung mit den quantisierten Spektralwerten bewirkt. Das Ausgangssignal des Quantisierers und Codierers wird neben dem Ausgangssignal des. Codierers der ersten Stufe in den Bitstrom geschrieben. Zunächst könnte daran gedacht werden, das eingangs beschriebene TNS-Filter direkt hinter dem Schaltmodul, d. h. vor dem Quantisierer/Codierer anzuordnen, um die in Fig. 10A gezeigte Struktur einfach nachzuahmen. Ein Nachteil dieser Lösung besteht jedoch darin, daß das Ausgangssignal des Schaltmoduls bezüglich des ursprünglichen zeitlichen Audiosignals am Eingang des Codierers stark verändert ist, weshalb eine Filterkoeffizientenbestimmung für das TNS-Filter nicht mit gleicher Qualität anwendbar ist.

Die Aufgabe der vorliegenden Erfindung besteht darin, das Konzept des skalierbaren Audiocodierens mit dem Konzept der zeitlichen Rauschformung zu verbinden, um auch bei skalierbaren Audiocodierern in den Genuß der zeitlichen Rauschformung zu kommen.

Diese Aufgabe wird durch ein Verfahren zum Codieren gemäß Anspruch 1 oder 2, durch ein Verfahren zum Decodieren gemäß Anspruch 3 oder 4, durch eine Vorrichtung zum Codieren gemäß Anspruch 5 oder 6 sowie durch eine Vorrichtung zum Decodieren gemäß Anspruch 7 oder 8 gelöst.

Der vorliegenden Erfindung liegt die Erkenntnis zugrunde, daß die Bestimmung der TNS-Filterkoeffizienten bzw. Prädiktionskoeffizienten unbedingt anhand von Spektralwerten durchgeführt werden muß, welche nicht durch den Codierer der ersten Stufe beeinflußt sind. Ein skalierbarer Audiocodierer soll ja zudem ein flexibler Codierer sein, bei dem als Codierer der ersten Stufe irgendeiner der in der Beschreibungseinleitung genannten Varianten eingesetzt werden kann. Erfindungsgemäß wird die Bestimmung der TNS-Prädiktionskoeffizienten aufgrund von Spektralwerten durchgeführt, die eine direkte Darstellung des Audiosignals am Eingang des Codierers sind. Mittels einer Filterbank oder einer MDCT kann eine Spektraldarstellung des Audiocodierereingangssignals erzeugt werden. Nun ist es jedoch nicht mehr möglich, die Bestimmung der TNS-Filterkoeffizienten an gleicher Stelle im Codierer wie die tatsächliche Filterung durch das TNS-Codierungsfilter durchzuführen. Die TNS-Filterkoeffizientenbestimmung muß daher getrennt vom tatsächlichen TNS-Codierungsfilter stattfinden.

Gemäß einem ersten Aspekt der vorliegenden Erfindung wird die TNS-Filterkoeffizientenbestimmung direkt hinter der Filterbank durchgeführt, welche das ursprüngliche Audioeingangssignal direkt in den Frequenzbereich transformiert. Vor dem Summierer bzw. dem Schaltmodul liegen somit Signale gleicher Art, d. h. nicht-TNS-verarbeitete Signale, an. Die TNS-Filterung mit den bereits bestimmten TNS-Koeffizienten findet gemäß dem ersten Aspekt der vorliegenden Erfindung hinter dem Schaltmodul und vor dem Quantisierer/Codierer, der nach dem psychoakustischen Modell arbeiten könnte, statt. Wie es später ersichtlich werden wird, erfordert diese Implementierung der TNS-Technik im skalierbaren Audiocodierer jedoch eine Änderung des Decodierers.

Gemäß einem zweiten Aspekt der vorliegenden Erfindung ist diese Decodierung jedoch nicht mehr notwendig. Wieder werden hier an gleicher Stelle wie beim ersten Aspekt der vorliegenden Erfindung TNS-Prädiktionskoeffizienten bestimmt. Im Gegensatz zum ersten Aspekt der vorliegenden Erfindung werden beide relevanten Spektralsignale, d. h. das Spektralsignal, das den Codierfehler der ersten Stufe aufweist, bzw. das Spektralsignal, das eine im wesentlichen ungestörte Darstellung des Audioeingangssignal ist, vor dem Summierglied einer Verarbeitung mit dem TNS-Codierungsfilter unterzogen werden, wobei das TNS-Codierungsfilter mittels der vorher bestimmten TNS-Koeffizienten arbeitet. Es wird besonders darauf hingewiesen, daß die TNS-Filterung des mit dem Codierungsfehler des Codierers der ersten Stufe behafteten Spektralsignals ohne Neubestimmung der TNS-Koeffizienten lediglich unter Verwendung der vom fehlerfreien Audiosignal abgeleiteten TNS-Koeffizienten arbeitet. Gemäß dem zweiten Aspekt der vorliegenden Erfindung liegen also wieder zwei Signale gleicher Art, d. h. hier TNS-verarbeitete Signale, am Eingang des Summierers bzw. des Schaltmoduls an.

Allgemein gesagt unterscheiden sich der erste und der zweite Aspekt der vorliegenden Erfindung darin, daß einmal vor dem Summierer nicht-TNS-verarbeitete Signale anliegen, während ein andermal TNS-verarbeitete Signale der Differenzbildung unterzogen werden bzw. in das Schaltmodul eingespeist werden.

Die genannten Verhältnisse werden bei den erfindungsgemäßen Decodierern berücksichtigt. Bei einem Decodierer, der ein gemäß dem ersten Aspekt der vorliegenden Erfindung codiertes Signal decodiert, findet die TNS-Decodierung, d. h. die Anwendung des TNS-Decodierfilters unter Verwendung der bei der Codierung bestimmten TNS-Koeffizienten, welche sich als Seiteninformationen im Bitstrom wiederfinden, vor einem zu dem Schaltmodul analogen inversen Schaltmodul statt. Das inverse Schaltmodul wird damit wie beim Codierer auch beim Decodierer mit nicht-TNS-verarbeiteten Signalen bedient.

Bei einem Decodierer, der gemäß dem zweiten Aspekt der vorliegenden Erfindung codierte Signale decodiert, wird das inverse Schaltmodul dagegen mit TNS-verarbeiteten Signalen gespeist. Zu diesem Zweck muß das decodierte Signal des Codierers der ersten Stufe in den Frequenzbereich umgesetzt werden und mittels eines TNS-Codierungsfilters gefiltert werden, das die im Codierer bestimmten TNS-Filterkoeffizienten verwendet. Nur dann werden im inversen Schaltmodul bzw. im davor angeordneten Addierer Signale gleicher Art, d. h. TNS-verarbeitete Signale, verglichen, wie es auch prinzipiell im Codierer gemäß dem zweiten Aspekt der Erfindung der Fall war. Die Ausgangssignale des inversen Schaltmoduls werden schließlich in ein TNS-Decodierungsfilter eingespeist, dessen Ausgangssignale dann einer inversen Filterbank unterzogen werden, um das ursprüngliche Audiosignal abgesehen von Codierungsfehlern der gesamten Anordnung wiederzugeben. Wie es bereits erwähnt wurde, wird der Codierer bzw. Decodierer gemäß dem zweiten Aspekt der vorliegenden Erfindung unter den erfindungsgemäßen Ausführungsbeispielen bevorzugt, da im Decodierer keine wesentlichen Änderungen erforderlich sind, da das TNS-Decodierungsfilter bzw. das inverse TNS-Filter vor der inversen Filterbank angeordnet ist, was der Anordnung von Fig. 10A entspricht.

Bevorzugte Ausführungsbeispiele der vorliegenden Erfindung werden nachfolgend bezugnehmend auf die beiliegenden Zeichnungen detaillierter erläutert. Es zeigen:
- Fig. 1: einen skalierbaren Audiocodierer gemäß einem ersten Aspekt der vorliegenden Erfindung;
- Fig. 2: einen skalierbaren Audiocodierer gemäß einem zweiten Aspekt der vorliegenden Erfindung;
- Fig. 3: einen Decodierer gemäß dem ersten Aspekt der vorliegenden Erfindung;
- Fig. 4: einen Decodierer gemäß dem zweiten Aspekt der vorliegenden Erfindung;
- Fig. 5: eine Tabelle zur Veranschaulichung der Dualität zwischen dem Zeit- und dem Frequenzbereich;
- Fig. 6A: ein Beispiel für ein transientes Signal;
- Fig. 6B: Hilbert-Hüllkurven von Teilbandpaßsignalen aufgrund des in Fig. 6A gezeigten transienten Zeitsignals;
- Fig. 7: eine Prinzipdarstellung der Prädiktion im Frequenzbereich;
- Fig. 8A: ein Beispiel zur Veranschaulichung der TNS-Technik;
- Fig. 8B: eine Gegenüberstellung des zeitlichen Verlaufs eines eingeführten Quantisierungsrauschens mit (links) und ohne (rechts) TNS-Technik;
- Fig. 9A: eine vereinfachte Blockdarstellung eines unskalierten Codierers, der ein TNS-Filter aufweist;
- Fig. 9B: eine Detaildarstellung des TNS-Filters von Fig. 9A;
- Fig. 10A: eine vereinfachte Blockdarstellung eines unskalierten Decodierers, der ein inverses TNS-Filter aufweist; und
- Fig. 10B: eine detailliertere Darstellung des inversen TNS-Filters von Fig. 10A.

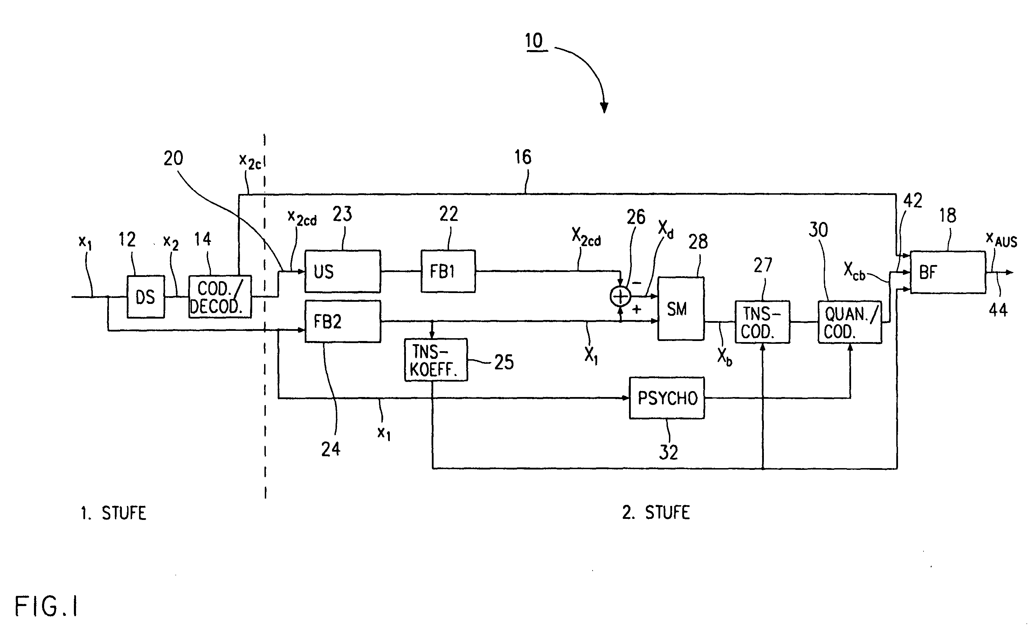

Fig. 1 zeigt ein Prinzipblockschaltbild eines skalierbaren Audiocoders gemäß der vorliegenden Erfindung. Ein mit einer ersten Abtastrate, z. B. 48 kHz, abgetastetes diskretes Zeitsignal x₁ wird mittels eines Downsampling-Filters 12 auf eine zweite Abtastrate, z. B. 8 kHz, gebracht, wobei die zweite Abtastrate kleiner als die erste Abtastrate ist. Vorzugsweise bilden die erste und die zweite Abtastrate ein ganzzahliges Verhältnis. Das Ausgangssignal des Downsampling-Filters 12, der als ein Dezimationsfilter implementiert sein kann, wird in einen Codierer/Decodierer 14 eingegeben, der sein Eingangssignal gemäß einem ersten Codieralgorithmus codiert. Der Codierer/Decodierer 14 kann, wie es bereits erwähnt wurde, ein Sprachcodierer niedrigerer Ordnung sein, wie z. B. ein Codierer G.729, G.723, FS1016, MPEG-4 CELP, MPEG-4 PAR. Solche Codierer arbeiten bei Datenraten von 4,8 Kilobit pro Sekunde (FS1016) bis zu Datenraten bei 8 Kilobit pro Sekunde (G.729). Alle verarbeiten Signale, die mit einer Abtastfrequenz von 8 kHz abgetastet worden sind. Für Fachleute ist es jedoch offensichtlich, daß beliebige andere Codierer mit anderen Datenraten bzw. anderen Abtastfrequenzen eingesetzt werden könnten.

Das von dem Codierer 14 codierte Signal, d.h. das codierte zweite Signal x_{2c}, das ein von dem Codierer 14 abhängiger Bitstrom ist und bei einer der genannten Bitraten vorliegt, wird über eine Leitung 16 in eine Bitformatiereinrichtung 18 eingegeben, wobei die Funktion der Bitformatiereinrichtung 18 später beschrieben wird. Das Downsampling-Filter 12 sowie der Codierer/Decodierer 14 bilden eine erste Stufe des skalierbaren Audiocodierers gemäß der vorliegenden Erfindung.

Die auf der Leitung 16 ausgegebenen codierten zweiten Zeitsignale x_{2c} werden ferner in dem ersten Codierer/Decodierer 14 wieder decodiert, um codierte/decodierte zweite Zeitsignale x_{2cd} auf einer Leitung 20 zu erzeugen. Die codierten/decodierten zweiten Zeitsignale x_{2cd} sind zeitdiskrete Signale, die eine im Vergleich zu den ersten diskreten Zeitsignalen x₁ reduzierte Bandbreite aufweisen. Bei dem genannten Zahlenbeispiel weist das erste diskrete Zeitsignal x₁ eine Bandbreite von maximal 24 kHz auf, da die Abtastfrequenz 48 kHz ist. Die codierten/decodierten zweiten Zeitsignale x_{2cd} weisen eine Bandbreite von maximal 4 kHz auf, da das Downsampling-Filter 12 das erste Zeitsignal x₁ mittels Dezimation auf eine Abtastfrequenz von 8 kHz umgesetzt hat. Innerhalb der Bandbreite von null bis 4 kHz sind die Signale x₁ und x_{2cd} abgesehen von durch den Codierer/Decodierer 14 eingeführten Codierungsfehlern gleich.

Hier sei angemerkt, daß die durch den Codierer 14 eingeführten Codierungsfehler nicht immer kleine Fehler sind, sondern daß dieselben ohne weiteres in Größenordnungen des Nutzsignals kommen können, wenn beispielsweise ein stark transientes Signal im ersten Codierer codiert wird. Aus diesem Grund wird überprüft, ob eine Differenzcodierung überhaupt sinnvoll ist, wie es weiter unten erklärt ist.

Das Signal x_{2cd} am Ausgang des Codierer/Decodierers 14 wird in ein Upsampling-Filter 23 eingespeist, um wieder auf die hohe Abtastrate umgesetzt zu werden, damit es mit dem Signal x₁ verglichen werden kann.

Das upgesamplte Signal x_{2cd} sowie das Signal x₁ werden jeweils in eine Filterbank FB1 22 bzw. in eine Filterbank FB2 24 eingespeist. Die Filterbank FB1 22 erzeugt Spektralwerte X_{2cd}, die eine Frequenzbereichsdarstellung der Signale X_{2cd} sind. Die Filterbank FB2 hingegen erzeugt Spektralwerte X₁, die eine Frequenzbereichsdarstellung des ursprünglichen ersten Zeitsignals x₁ sind. Die Ausgangssignale der beiden Filterbänke werden in einer Summationseinrichtung 26 subtrahiert. Genauer gesagt werden die Ausgangsspektralwerte X_{2cd} der Filterbank FB1 22 von den Ausgangsspektralwerten der Filterbank FB2 24 subtrahiert. Der Summationseinrichtung 26 nachgeschaltet ist ein Schaltmodul SM 28, das als Eingangssignal sowohl das Ausgangssignal X_{d} der Summationseinrichtung 26 als auch das Ausgangssignal X₁ der Filterbank 24, d.h. die Spektraldarstellung der ersten Zeitsignale, welche nachfolgend als erste Spektralwerte X₁ bezeichnet werden, erhält.

Gemäß einem ersten Aspekt der vorliegenden Erfindung werden mittels einer Einrichtung 25 zum Berechnen der TNS-Koeffizienten Prädiktionskoeffizienten für ein TNS-Filter bzw. für ein Prädiktionsfilter 27 berechnet, das hinter dem Schaltmodul 28 angeordnet ist. Die TNS-Koeffizientenberechnungseinrichtung 25 speist die Koeffizienten sowohl in das TNS-Codierungsfilter 27 als auch in die Bitformatierungseinrichtung 18, wie es aus Fig. 1 ersichtlich ist.

Das TNS-Codierungsfilter speist eine Quantisierungs/Codierungseinrichtung 30, die eine für Fachleute bekannte Quantisierung unter Berücksichtigung eines psychoakustischen Modells durchführt, das durch ein psychoakustisches Modul 32 symbolisiert ist. Die beiden Filterbänke 22, 24, die Summationseinrichtung 26, das Schaltmodul 28, der Quantisierer/Codierer 30 und das psychoakustische Modul 32 bilden eine zweite Stufe des skalierbaren Audiocoders gemäß der vorliegenden Erfindung.

Im nachfolgenden wird der Betrieb des skalierbaren Audiocodierers gemäß Fig. 1 erklärt. Die diskreten, mit einer ersten Abtastrate abgetasteten ersten Zeitsignale x₁ werden, wie es bereits erwähnt wurde, in das Downsampling-Filter 12 eingespeist, um zweite Zeitsignale x₂ zu erzeugen, deren Bandbreite einer zweiten Abtastrate entspricht, wobei die zweite Abtastrate kleiner als die erste Abtastrate ist. Der Codierer/Decodierer 14 erzeugt aus dem zweiten Zeitsignalen x₂ gemäß eines ersten Codieralgorithmus zweite codierte Zeitsignale x_{2c} sowie mittels einer anschließenden Decodierung gemäß dem ersten Codierungsalgorithmus codierte/decodierte zweite Zeitsignale x_{2cd}. Die codierten/decodierten zweiten Zeitsignale x_{2cd} werden mittels der ersten Filterbank FB1 22 in den Frequenzbereich transformiert, um zweite Spektralwerte X_{2cd} zu erzeugen, die eine Frequenzbereichsdarstellung der codierten/decodierten zweiten Zeitsignale x_{2cd} sind.

An dieser Stelle sei angemerkt, daß die codierten/decodierten zweiten Zeitsignale x_{2cd} Zeitsignale mit der zweiten Abtastfrequenz, d.h. 8 kHz beim Beispiel, sind. Die Frequenzbereichsdarstellung dieser Signale und die ersten Spektralwerte X₁ sollen nun bewertet werden, wobei die ersten Spektralwerte X₁ mittels der zweiten Filterbank FB2 24 aus dem ersten Zeitsignal x₁, das die erste, d. h. hohe, Abtastfrequenz aufweist, erzeugt werden. Um vergleichbare Signale zu erhalten, die eine identische Zeit- und Frequenzauflösung haben, muß das 8-kHz-Signal, d.h. das Signal mit der zweiten Abtastfrequenz, auf ein Signal mit der ersten Abtastfrequenz überführt werden. Für den skalierbaren Codierer ist es jedoch nicht zwingend, daß die beiden Abtastfrequenzen unterschiedlich sind, dieselben können auch gleich sein.

Dies kann statt des Upsampling-Filters auch dadurch geschehen, daß zwischen die einzelnen zeitdiskreten Abtastwerte des Signals x_{2cd} eine bestimmte Anzahl von Nullwerten eingefügt wird. Die Anzahl der Nullwerte errechnet sich aus dem Verhältnis der ersten Abtastfrequenz und der zweiten Abtastfrequenz - 1. Das Verhältnis der ersten (hohen) zur zweiten (niedrigen) Abtastfrequenz wird als Upsampling-Faktor bezeichnet. Wie es Fachleuten bekannt ist, wird durch das Einfügen von Nullen, das mit sehr geringem Rechenaufwand möglich ist, eine Aliasing-Störung in dem Signal x_{2cd} erzeugt, die sich derart auswirkt, daß das niederfrequente oder Nutzspektrum des Signals x_{2cd} wiederholt wird, und zwar insgesamt so oft, wie viel Nullen eingefügt werden. Das Aliasing-behaftete Signal x_{2cd} wird nun mittels der ersten Filterbank FB1 in den Frequenzbereich transformiert, um zweite Spektralwerte X_{2cd} zu erzeugen.

Durch das Einfügen von z.B. fünf Nullen zwischen jeden Abtastwert des codierten/decodierten zweiten Signals x_{2cd} entsteht ein Signal, von dem von vorneherein bekannt ist, daß lediglich jeder sechste Abtastwert dieses Signals von Null verschieden ist. Diese Tatsache kann beim Transformieren dieses Signals in den Frequenzbereich mittels einer Filterbank oder MDCT oder mittels einer beliebigen Fourier-Transformation ausgenützt werden, da beispielsweise auf bestimmte Summationen, die bei einer einfachen FFT auftreten, verzichtet werden kann. Die von vorneherein bekannte Struktur des zu transformierenden Signals kann somit auf vorteilhafte Weise zur Rechenzeiteinsparung bei einer Transformation desselben in den Frequenzbereich verwendet werden.

Die zweiten Spektralwerte X_{2cd} sind nur im unteren Teil eine korrekte Darstellung des codierten/decodierten zweiten Zeitsignals x_{2cd}, weshalb am Ausgang der Filterbank FB1 nur maximal das 1/Upsampling-Faktor-fache der gesamten Spektrallinien x_{2cd} verwendet wird. An dieser Stelle sei angemerkt, daß die verwendete Anzahl der Spektrallinien X_{2cd} durch das Einfügen der Nullen in dem codierten/decodierten zweiten Zeitsignal x_{2cd} nun dieselbe Zeit- und Frequenzauflösung besitzt, wie die ersten Spektralwerte X₁, die eine Frequenzdarstellung ohne Aliasing-Störung des ersten Zeitsignals x₁ ist. In der Subtrahiereinrichtung 26 sowie in dem Schaltmodul 28 werden die beiden Signale X_{2cd} und X₁ bewertet, um bewertete Spektralwerte X_{b} oder X₁ zu erzeugen. Das Schaltmodul 28 führt nun eine sogenannte Simulcast-Differenz-Umschaltung durch.

Nicht immer ist es günstig, eine Differenzcodierung in der zweiten Stufe zu verwenden. Dies ist beispielsweise dann der Fall, wenn das Differenzsignal, d. h. das Ausgangssignal der Summationseinrichtung 26, eine höhere Energie als das Ausgangssignal der zweiten Filterbank X₁ aufweist. Da ferner für den Codierer/Decodierer 14 der ersten Stufe ein beliebiger Codierer verwendet werden kann, kann es vorkommen, daß der Codierer bestimmte in der zweiten Stufe schwer zu codierende Signalanteile produziert. Der Codierer/Decodierer 14 soll vorzugsweise Phaseninformationen des von ihm codierten Signals bewahren, was in der Fachwelt als "Wave-Form-Coding" oder "Signalformcodieren" bezeichnet wird. Die Entscheidung in dem Schaltmodul 28 der zweiten Stufe, ob eine Differenzcodierung oder eine Simulcast-Codierung verwendet wird, wird frequenzabhängig getroffen.

"Differenzcodierung" bedeutet, daß lediglich die Differenz der zweiten Spektralwerte X_{2cd} und der ersten Spektralwerte X₁ codiert wird. Falls diese Differenzcodierung jedoch nicht günstig ist, da der Energieinhalt des Differenzsignals größer als der Energieinhalt der ersten Spektralwerte X₁ ist, dann wird von einer Differenzcodierung abgesehen. Wird von einer Differenzcodierung abgesehen, dann werden die ersten Spektralwerte X₁ des im Beispiel mit 48 kHz abgetasteten Zeitsignals x₁ vom Schaltmodul 28 durchgeschaltet und als Ausganssignal des Schaltmoduls SM 28 verwendet.

Da die Differenzbildung im Frequenzbereich stattfindet, ist es ohne weiteres möglich, eine frequenzselektive Auswahl von Simulcast- oder Differenzcodierung durchzuführen, da die Differenz der beiden Signale X₁ und X_{2cd} ohnehin berechnet wird. Die Differenzbildung im Spektrum erlaubt somit eine einfache frequenzselektive Wahl der Frequenzbereiche, welche differenzcodiert werden sollen. Prinzipiell könnte eine Umschaltung von einer Differenz- zu einer Simulcast-Codierung für jeden Spektralwert einzeln auftreten. Dies wird jedoch eine zu große Menge an Seiteninformationen erfordern und nicht unbedingt nötig sein. Daher wird es bevorzugt, beispielsweise ein frequenzgruppenweises Vergleichen der Energien der Differenzspektralwerte und der ersten Spektralwerte durchzuführen. Alternativ dazu können bestimmte Frequenzbänder von vornherein festgelegt werden, z. B. acht Bänder von jeweils 500 Hz Breite, wodurch sich wieder die Bandbreite des Signals X_{2cd} ergibt, wenn das Zeitsignal x₂ eine Bandbreite von 4 kHz aufweist. Ein Kompromiß bei der Festlegung der Frequenzbänder besteht darin, die Menge der zu übertragenden Seiteninformationen, d. h. ob in einem Frequenzband die Differenzcodierung aktiv ist oder nicht, gegenüber dem Nutzen abzuwägen, der aus einer möglichst häufigen Differenzcodierung erwächst.

Im Bitstrom können Seiteninformationen, beispielsweise 8 Bit für jedes Band, ein Ein/Aus-Bit für die Differenzcodierung oder auch eine andere geeignete Codierung übertragen werden, die anzeigen, ob ein bestimmtes Frequenzband differenzcodiert ist oder nicht. Im Decodierer, welcher später beschrieben wird, werden dann dementsprechend bei der Rekonstruktion nur die entsprechenden Teilbänder des ersten Codierers addiert.

Ein Schritt des Bewertens der ersten Spektralwerte X₁ und der zweiten Spektralwerte X_{2cd} umfaßt somit vorzugsweise das Subtrahieren der zweiten Spektralwerte X_{2cd} von den ersten Spektralwerten X₁, um Differenzspektralwerte X_{d} zu erhalten. Zudem werden dann auf bekannte Art und Weise, beispielsweise durch Summieren und Quadrieren, die Energien mehrerer Spektralwerte in einem vorbestimmten Band, beispielsweise 500 Hz beim 8-kHz-Beispiel, für die Differenz-Spektralwerte X_{d} sowie für die ersten Spektralwerte X₁ berechnet. In jedem Frequenzband wird nun ein frequenzselektives Vergleichen der jeweiligen Energien durchgeführt. Falls die Energie in einem bestimmten Frequenzband der Diffenzspektralwerte X_{d} die Energie der ersten Spektralwerte X₁ multipliziert mit einem vorbestimmten Faktor k überschreitet, wird bestimmt, daß die bewerteten Spektralwerte X_{b} die ersten Spektralwerte X₁ sind. Andernfalls wird bestimmt, daß die Differenz-Spektralwerte Xd die bewerteten Spektralwerte X_{b} sind. Der Faktor k kann beispielsweise etwa von 0,1 bis 10 reichen. Bei Werten von k kleiner 1 wird bereits eine Simulcast-Codierung eingesetzt, wenn das Differenzsignal eine geringere Energie als das Ursprungssignal aufweist. Bei Werten von k größer 1 wird dagegen weiter eine Differenzcodierung verwendet, selbst wenn der Energieinhalt des Differenzsignals bereits größer als der des nicht im ersten Codierer codierten Ursprungssignals ist. Wird eine Simulcast-Codierung bewertet, wird das Schaltmodul 28 die Ausgangssignale der zweiten Filterbank 24 gewissermaßen direkt durchschalten. Als Alternative zu der beschriebenen Differenzbildung kann auch eine Bewertung derart durchgeführt werden, daß z. B. ein Verhältnis oder eine Multiplikation oder eine sonstige Verknüpfung der beiden genannten Signale durchgeführt wird.

Das TNS-Codierungsfilter 27, das mit dem Ausgang des Schaltmoduls 28 verbunden ist, führt nun eine Prädiktion der bewerteten Spektralwerte X_{b} über der Frequenz mittels der durch die TNS-Koeffizientenberechnungseinrichtung 25 berechneten Prädiktionskoeffizienten durch, um bewertete spektrale Restwerte zu erhalten.

Die bewerteten spektralen Restwerte, die entweder den Differenzspektralwerten X_{d} oder den ersten Spektralwerte X₁ entsprechen, wie es durch das Schaltmodul 28 bestimmt wurde, werden nun mittels eines ersten Quantisierers/Codierers 30 unter Berücksichtigung des psychoakustischen Models, das für Fachleute bekannt ist und in dem psychoakustischen Modell 32 vorhanden ist, quantisiert und anschließend vorzugsweise mittels einer Redundanz-reduzierenden Codierung, beispielsweise unter Verwendung von Huffman-Tabellen, codiert. Wie es für Fachleute ferner bekannt ist, wird das psychoakustische Modell aus Zeitsignalen berechnet, weshalb das erst Zeitsignal x₁ mit der hohen Abtastrate direkt in das psychoakustische Modul 32 eingespeist wird, wie es in Fig. 1 zu sehen ist. Das Ausgangssignal X_{cb} des Quantisierers/Codierers 30 wird auf der Leitung 42 direkt zur Bitformatiereinrichtung 18 geleitet und ins Ausgangsignal x_{AUS} geschrieben.

Im Vorhergehenden wurde ein skalierbarer Audiocodierer mit einer ersten und einer zweiten Stufe beschrieben. Das erfindungsgemäße Konzept des skalierbaren Audiocodierers ist in der Lage, auch mehr als zwei Stufen zu kaskadieren. So wäre es beispielsweise möglich, bei einem Eingangssignal x₁, das mit 48 kHz abgetastet ist, im ersten Codierer/Decodierer 14 mittels Reduzierung der Abtastrate die ersten 4 kHz des Spektrums zu codieren, um eine Signalqualität nach der Decodierng zu erreichen die etwa der Sprachqualität von Telefongesprächen entspricht. In der zweiten Stufe könnte, implementiert durch den Quantisierer/Codierer 30, eine Bandbreitencodierung von bis zu 12 kHz durchgeführt werden, um eine Tonqualität zu erreichen, die etwa der HIFI-Qualität entspricht. Für Fachleute ist es offensichtlich, daß ein mit 48 kHz abgetastetes Signal x₁ eine Bandbreite von 24 kHz haben kann. Die dritte Stufe könnte nun implementiert durch den weiteren Quantisierer/Codierer eine Codierung bis zu einer Bandbreite von maximal 24 kHz oder bei einem praktischen Beispiel von z. B. 20 kHz durchführen, um eine Tonqualität zu erreichen, die etwa der einer Compact Disc (CD) entspricht.

Der codierte Datenstrom x_{AUS} setzt sich neben den ebenfalls zu übertragenden Seiteninformationen aus folgenden Signalen zusammen:
- den codierten zweiten Signalen x_{2c} (volles Spektrum von 0 bis 4 kHz); und
- den codierten bewerteten spektralen Restwerten (volles Spektrum von 0 bis 12 kHz bei einer Simulcast-Codierung oder Codierfehler von 0 bis 4 kHz des Codierers 14 und volles Spektrum von 4 bis 12 kHz bei einer Differenzcodierung).

Eventuell können beim Übergang vom ersten Codierer/Decodierer 14 zum Quantisierer/Codierer 30 im Beispiel beim Übergang von 4 kHz auf einen größeren Wert als 4 kHz Übergangsstörungen auftreten. Diese Übergangsstörungen können sich in fehlerhaften Spektralwerten äußern, die in den Bitstrom x_{AUS} geschrieben werden. Der Gesamtcodierer/Decodierer kann nun so spezifiziert werden, daß z. B. nur die Frequenzlinien bis 1/(Upsampling-Faktor minus x) (x = 1, 2, 3) verwendet werden. Dies führt dazu, daß die letzten Spektrallinien des Signals X_{2cd} am Ende der gemäß der zweiten Abtastfrequenz erreichbaren maximalen Bandbreite nicht berücksichtigt werden. Implizit wird also eine Bewertungsfunktion verwendet, die beim genannten Fall eine Rechteckfunktion ist, die über einem bestimmten Frequenzwert Null ist und darunter einen Wert von Eins aufweist. Alternativ dazu kann auch eine "weichere" Bewertungsfunktion eingesetzt werden, die Spektrallinien, die Übergangsstörungen haben, in ihrer Amplitude reduziert, wonach die in ihrer Amplitude reduzierten Spektrallinien doch berücksichtigt werden.

An dieser Stelle sei angemerkt, daß die Übergangsstörungen nicht hörbar sind, da sie im Decodierer wieder eliminiert werden. Die Übergangsstörungen können jedoch zu überhöhten Differenzsignalen führen, für die dann der Codierungsgewinn durch die Differenzcodierung verringert wird. Durch Bewerten mit einer Bewertungsfunktion, wie sie oben beschrieben wurde, kann somit ein Verlust an Codierungsgewinn in Grenzen gehalten werden. Eine andere Bewertungsfunktion als die Rechteckfunktion wird keine zusätzlichen Seiteninformationen benötigen, da dieselbe genauso wie die Rechteckfunktion a priori für den Codierer und den Decodierer vereinbart werden kann.

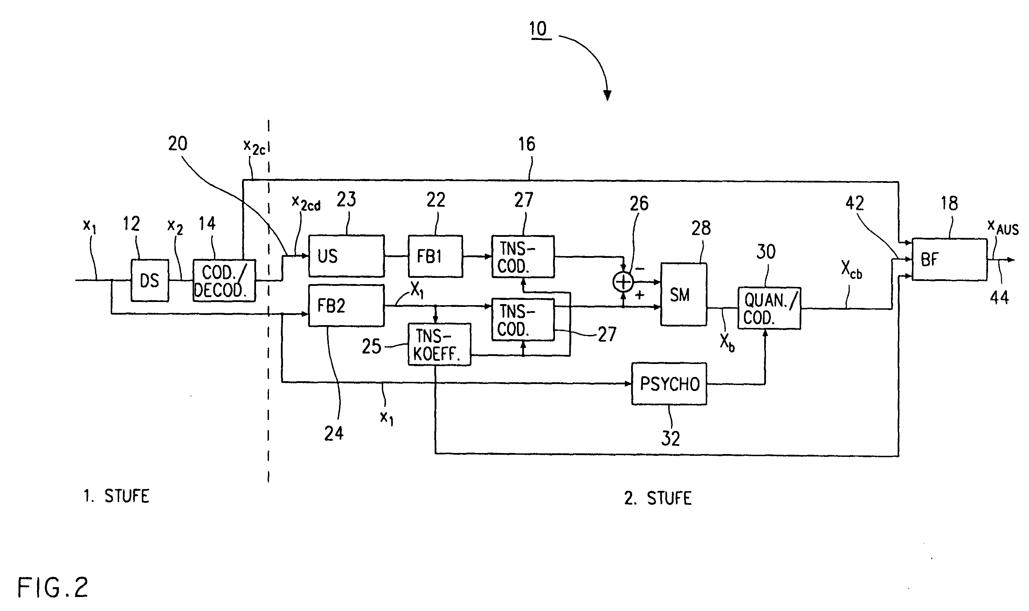

Fig. 2 zeigt eine praktische Implementation eines Codierers, der gemäß dem zweiten Aspekt der vorliegenden Erfindung arbeitet. Gleiche Elemente wie in Fig. 1 tragen die gleichen Bezugszeichen und erfüllen, wenn nicht explizit darauf hingewiesen wird, dieselben Funktionen. Wie es bereits dargestellt wurde, ist der zweite Aspekt der vorliegenden Erfindung für den Decodierer günstiger, da derselbe geringere Modifikationen erforderlich macht. Im Gegensatz zum skalierbaren Audiocodierer von Fig. 1 ist in Fig. 2 ein zweites TNS-Codierungsfilter 27 hinter der Filterbank 1 der Stelle 22 angeordnet. Ferner ist das erste TNS-Codierungsfilter bereits hinter der Filterbank 2 24 angeordnet, was dazu führt, daß die Summierer in Einrichtung 26 sowie das Schaltmodul 28 TNS-verarbeitete, d. h. erste spektrale Restwerte bzw. zweite spektrale Restwerte, verarbeiten. Es werden also in dem Schaltmodul 28 und der Summiereinrichtung 26 die ersten spektralen Restwerte mit den zweiten spektralen Restwerten bewertet, um bewertete spektrale Restwerte zu erhalten, die dann in den Quantisierer/Codierer 30 eingespeist werden. Derselbe quantisiert bzw. codiert ebenso wie in Fig. 1 somit bewertete spektrale Restwerte. Die TNS-Koeffizientenberechnungseinrichtung 25 speist sowohl den TNS-Codierer hinter der Filterbank 24 als auch den TNS-Codierer hinter der Filterbank 22, wobei das Ausgangssignal der Filterbank 22 jedoch einer TNS-Filterung unterzogen wird, die auf der Basis der TNS-Koeffizienten durchgeführt wird, die aus dem Ausgangssignal der Filterbank 24 berechnet worden sind. Ebenso wie in Fig. 1 werden die TNS-Koeffizienten der Bitstromformatierungseinrichtung 18 als Seiteninformationen zugeführt.

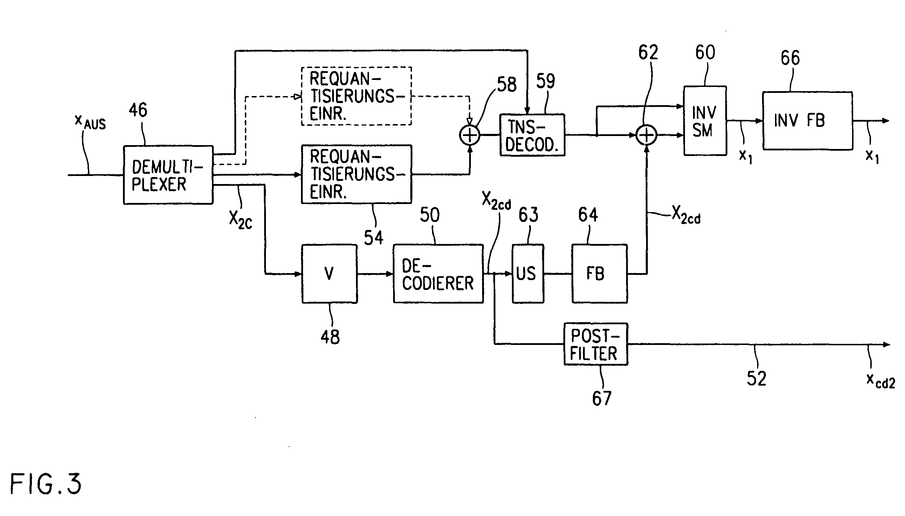

Fig. 3 zeigt einen Decodierer zum Decodieren von mittels dem skalierbaren Audiocoderer gemäß Fig. 1 codierten Daten. Der Ausgangsdatenstrom des Bitformatierers 18 von Fig. 1 wird in einen Demultiplexer 46 eingespeist, um die bezüglich Fig. 1 auf den Leitungen 42 und 16 vorhandenen Signale aus dem Datenstrom x_{AUS} zu gewinnen. Die codierten zweiten Signale x_{2c} werden in ein Verzögerungsglied 48 eingespeist, wobei das Verzögerungsgleid 48 eine Verzögerung in die Daten einführt, die aufgrund anderer Gesichtspunkte des Systems notwendig sein kann und keinen Teil der Erfindung darstellt.

Nach der Verzögerung werden die codierten zweiten Signale x_{2c} in einen Decodierer 50 eingespeist, der mittels des ersten Codierungsalgorithmus, der auch in dem Codierer/Decodierer 14 von Fig. 1 implementiert ist, decodiert, um das codierte/decodierte zweite Zeitsignal x_{cd2} zu erzeugen, das über eine Leitung 52 ausgegeben werden kann, wie es in Fig. 3 zu sehen ist. Die codierten bewerteten spektralen Restwerte werden mittels einer Requantisierungseinrichtung 54 requantisiert, um die bewerteten spektralen Restwerte zu erhalten. Eine Summationseinrichtung 58 bildet die Summe der spektralen Restwerte und der spektralen Restwerte einer optionalen weiteren Schicht (gestrichelt gezeichnet).

Um vor einer Summationseinrichtung 62, die analog zur Einrichtung 26 arbeitet, wieder gleiche Verhältnisse zu schaffen, befindet sich hinter dem Summierer 58 ein TNS-Decodierungsfilter 59. Das TNS-Decodierungsfilter 59 führt eine inverse TNS-Filterung mit dem Ausgangssignal des Summierers 58 durch. Dabei werden die Prädiktionskoeffizienten verwendet, die in den Seiteninformationen vorhanden sind, wobei dieselben durch die TNS-Koeffizienteneinrichtung 25 von Fig. 2 berechnet wurden. Am Ausgang der TNS-Decodierungseinrichtung 59 befinden sich dann die wieder decodierten bewerteten Spektralwerte X_{b}.

An dieser Stelle sei angemerkt, daß, wie aus Fig. 3 ersichtlich ist, das codierte/decodierte zweite Zeitsignal zunächst mittels eines geeigneten Upsampling-Filters 63 umgesetzt und mittels einer Filterbank 64 in den Frequenzbereich transformiert werden muß, um die zweiten Spektralwerte X_{2cd} zu erhalten, da die Summation der Summationseinrichtung 62 eine Summation von Spektralwerten ist. Die Filterbank 64 ist vorzugsweise mit den Filterbänken FB1 22 und FB2 24 identisch, wodurch nur eine Einrichtung implementiert werden muß, die bei Verwendung geeigneter Puffer nacheinander mit verschiedenen Signalen gespeist wird. Alternativ können auch geeignete unterschiedliche Filterbanken eingesetzt werden.

Wie es bereits erwähnt wurde, werden aus dem ersten Zeitsignal x₁ mittels des psychoakustischen Moduls 32 Informationen abgeleitet, die bei der Quantisierung von Spektralwerten verwendet werden. Insbesondere besteht die Bestrebung, im Sinne einer Minimierung der zu übertragenden Datenmenge, die Spektralwerte möglichst grob zu quantisieren. Andererseits sollen durch die Quantisierung eingeführte Störungen nicht hörbar sein. Ein in dem psychoakustischen Modul 32 vorhandenes an sich bekanntes Modell wird verwendet, um eine erlaubte Störungsenergie zu berechnen, die durch die Quantisierung eingeführt werden kann, damit keine Störung hörbar ist. Eine Steuerung steuert nun in einem bekannten Quantisierer/Codierer den Quantisierer, um eine Quantisierung durchzuführen, die eine Quantisierungsstörung einführt, die kleiner oder gleich der erlaubten Störung ist. Dies wird bei bekannten Systemen ständig überwacht, indem das durch den Quantisierer, der z. B. im Block 30 enthalten ist, quantisierte Signal wieder dequantisiert wird. Durch Vergleich des Eingangssignals in den Quantisierer mit dem quantisierten/dequantisierten Signal wird die tatsächlich durch die Quantisierung eingeführte Störungsenergie berechnet. Die tatsächliche Störungsenergie des quantisierten/dequantisierten Signals wird in der Steuerung mit der erlaubten Störungsenergie verglichen. Ist die tatsächliche Störungsenergie größer als die erlaubte Störungsenergie, so wird die Steuerung in dem Quantisierer eine feinere Quantisierung einstellen. Der Vergleich zwischen erlaubter und tatsächlicher Störungsenergie findet typischerweise pro psychoakustischem Frequenzband statt. Dieses Verfahren ist bekannt und wird von dem skalierbaren Audiocoder gemäß der vorliegenden Erfindung verwendet, wenn eine Simulcast-Codierung verwendet wird.

Am Ausgang des Decodierers 50 findet sich ein sog. Post-Filter 67, das bestimmte Nachfilterungen des Ausgangssignals des Decodierers, der dem Decodierer der ersten Stufe entspricht, vornehmen kann. Dieses Filter stellt jedoch keinen Teil der Erfindung dar.

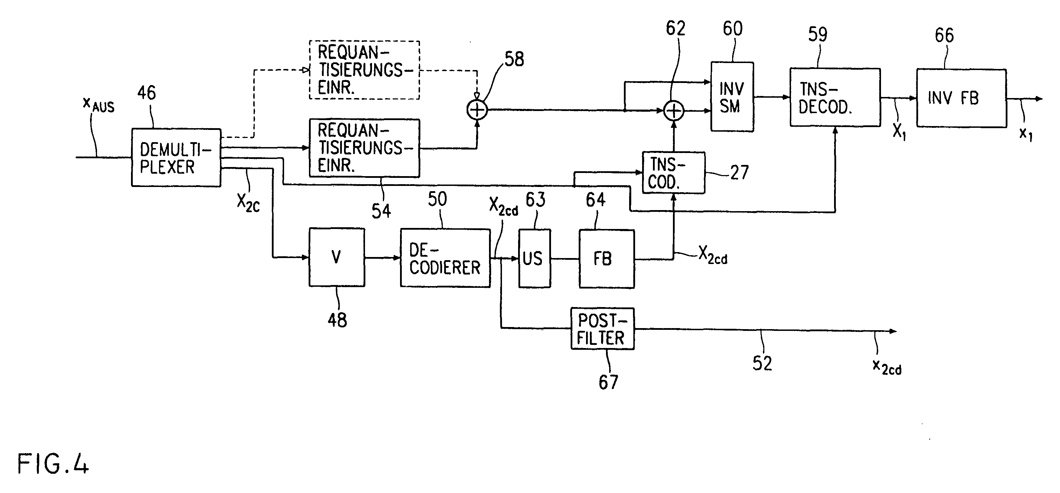

Fig. 4 zeigt eine zu Fig. 3 ähnlichen Decodierer. Der in Fig. 4 gezeigte Decodierer arbeitet jedoch für Signale, die gemäß dem zweiten Aspekt der vorliegenden Erfindung codiert worden sind. Im Gegensatz zu Fig. 3 arbeitet hier das inverse Schaltmodul 60 mit TNS-codierten Eingangssignalen, während das inverse Schaltmodul 60 von Fig. 3 mit nicht-TNS-verarbeiteten Signalen, d. h. TNS-decodierten Signalen, arbeitet. Da das Ausgangssignal des Decodierers 50 an keiner Stelle, auch nicht im Codierer, TNS-codiert wurde, muß es durch ein TNS-Codierungsfilter 27, das genauso wie die TNS-Codierungsfilter 27 der Fig. 1 und 2 ausgeführt sein kann, gefiltert werden. Das schließliche TNS-Decodierungsfilter 59 befindet sich beim Decodierer gemäß dem zweiten Aspekt der vorliegenden Erfindung direkt vor der inversen Filterbank 66, die die Filterbankoperationen der Filterbänke 22 und 24 rückgängig machen kann. Diese Anordnung wird bevorzugt, da sie der in Fig. 10a dargestellten Anordnung entspricht, welche üblicherweise in Transformationscodierern gefunden werden kann. Sowohl das TNS-Decodierungsfilter 59 als auch das TNS-Codierungsfilter 27 werden mit Prädiktionskoeffizienten versorgt, die der Demultiplexer 46 aus den Seiteninformationen des codierten Bitstroms xₐᵤₛ extrahiert.

Das zusätzliche TNS-Codierungsfilter 27 im Decodierer gemäß Fig. 4 stellt lediglich einen minimal höheren Aufwand dar, da die bei der TNS-Filterparameterbestimmung ermittelten Parameter ohnehin übertragen werden, um das TNS-Decodierungsfilter rechnen zu können. Dieselben sind hinreichend, um auch im Decodierer das TNS-Codierungsfilter zu berechnen. Es ist keine Änderung des übertragenen Bitstroms nötig.

Für Fachleute ist offensichtlich, daß das gegebene Beispiel, bei dem die ersten Abtastfrequenz 48 kHz beträgt und die zweite Abtastfrequenz 8 kHz beträgt, lediglich beispielhaft ist. Als zweite niederere Abtastfrequenz kann auch eine kleinere Frequenz als 8 kHz verwendet werden. Als Abtastfrequenzen für das Gesamtsystem können 48 kHz, 44,1 kHz, 32 kHz, 24 kHz, 22,05 kHz, 16 kHz, 8 kHz oder eine andere geeignete Abtastfrequenz verwendet werden. Der Bitratenbereich des Codierers/ Decodierers 14 der ersten Stufe kann, wie es bereits erwähnt wurde, von 4,8 kBit pro Sekunde bis zu 8 kBit pro Sekunde reichen. Der Bitratenbereich des zweiten Codierers in der zweiten Stufe kann von 0 bis 64, 69,659, 96, 128, 192 oder 256 kBit pro Sekunde bei Abtastraten von 48, 44,1, 32, 24, 16 bzw 8 kHz reichen. Der Bitratenbereich des Codierers der dritten Stufen kann von 8 kBit pro Sekunde bis 448 kBit pro Sekunde für alle Abtastraten reichen.

## Patentansprüche

1. Verfahren zum Codieren von diskreten, mit einer ersten Abtastrate abgetasteten ersten Zeitsignalen (x₁), mit folgenden Schritten:
Erzeugen von zweiten Zeitsignalen (x₂), deren Bandbreite einer zweiten Abtastrate entspricht, aus den ersten Zeitsignalen (x₁), wobei die zweite Abtastrate gleich oder kleiner als die erste Abtastrate ist;
Codieren der zweiten Zeitsignale (x₂) gemäß einem ersten Codieralgorithmus, um codierte zweite Signale (x_{2c}) zu erhalten;
Decodieren der codierten zweiten Signale (x_{2c}) gemäß dem ersten Codieralgorithmus, um codierte/decodierte zweite Zeitsignale (x_{2cd}) zu erhalten, deren Bandbreite der zweiten Abtastfrequenz entspricht;
Transformieren der ersten Zeitsignale (x₁) in den Frequenzbereich, um erste Spektralwerte (X₁) zu erhalten;
Berechnen von Prädiktionskoeffizienten aus den ersten Spektralwerten (X₁);
Erzeugen von zweiten Spektralwerten (X_{2cd}) aus codierten/decodierten zweiten Zeitsignalen (x_{2cd}), wobei die zweiten Spektralwerte (X_{2cd}) eine Darstellung der codierten/decodierten zweiten Zeitsignale (x_{2cd}) im Frequenzbereich sind;
Bewerten der ersten Spektralwerte (X₁) mit den zweiten Spektralwerten (X_{2cd}), um bewertete Spektralwerte (X_{b}) zu erhalten, deren Anzahl der Anzahl der ersten Spektralwerte (X₁) entspricht;
Durchführen einer Prädiktion der bewerteten Spektralwerte über der Frequenz mittels der berechneten Prädiktionskoeffizienten, um bewertete spektrale Restwerte zu erhalten; und
Codieren der bewerteten spektralen Restwerte gemäß einem zweiten Codieralgorithmus, um codierte bewertete spektrale Restwerte zu erhalten.

2. Verfahren zum Codieren von diskreten, mit einer ersten Abtastrate abgetasteten ersten Zeitsignalen (x₁), mit folgenden Schritten:
Erzeugen von zweiten Zeitsignalen (x₂), deren Bandbreite einer zweiten Abtastrate entspricht, aus den ersten Zeitsignalen (x₁), wobei die zweite Abtastrate gleich oder kleiner als die erste Abtastrate ist;
Codieren der zweiten Zeitsignale (x₂) gemäß einem ersten Codieralgorithmus, um codierte zweite Signale (x_{2c}) zu erhalten;
Decodieren der codierten zweiten Signale (x_{2c}) gemäß dem ersten Codieralgorithmus, um codierte/decodierte zweite Zeitsignale (x_{2cd}) zu erhalten, deren Bandbreite der zweiten Abtastfrequenz entspricht;
Transformieren der ersten Zeitsignale (x₁) in den Frequenzbereich, um erste Spektralwerte (X₁) zu erhalten;
Berechnen von Prädiktionskoeffizienten aus den ersten Spektralwerten (X₁);
Erzeugen von zweiten Spektralwerten (X_{2cd}) aus codierten/decodierten zweiten Zeitsignalen (x_{2cd}), wobei die zweiten Spektralwerte (X_{2cd}) eine Darstellung der codierten/decodierten zweiten Zeitsignale (x_{2cd}) im Frequenzbereich sind;
Durchführen einer Prädiktion der ersten Spektralwerte (X₁) und der zweiten Spektralwerte (X_{2cd}) über der Frequenz, um erste spektrale Restwerte bzw. zweite spektrale Restwerte zu erhalten, unter Verwendung der berechneten Prädiktionskoeffizienten.
Bewerten der ersten spektralen Restwerte mit den zweiten spektralen Restwerten, um bewertete spektrale Restwerte zu erhalten, deren Anzahl der Anzahl der ersten Spektralwerte (X₁) entspricht; und
Codieren der bewerteten spektralen Restwerte (X_{b}) gemäß einem zweiten Codieralgorithmus, um codierte bewertete spektrale Restwerte zu erhalten.

3. Verfahren zum Decodieren eines Bitstroms, der ein Audiosignal darstellt, wobei der Bitstrom gemäß einem ersten Codieralgorithmus codierte Signale, gemäß einem zweiten Codieralgorithmus codierte Signale und Seiteninformationen aufweist, wobei die gemäß dem zweiten Codieralgorithmus codierten Signale codierte spektrale Restwerte aufweisen, wobei die spektralen Restwerte durch Prädiktion über der Frequenz aus bewerteten Spektralwerten erzeugt sind, wobei Prädiktionskoeffizienten der Prädiktion in den Seiteninformationen vorhanden sind, mit folgenden Schritten:
Decodieren der gemäß dem ersten Codieralgorithmus codierten Signale (x_{2c}), um codierte, decodierte zweite Zeitsignale (x_{2cd}) zu erhalten, mittels des ersten Codieralgorithmus;
Decodieren der codierten spektralen Restwerte mittels des zweiten Codieralgorithmus, um die spektralen Restwerte zu erhalten;
Transformieren der codierten/decodierten zweiten Zeitsignale (x₂) in den Frequenzbereich, um die zweiten Spektralwerte (X_{2cd}) zu erhalten;
Durchführen einer inversen Prädiktion mit den bewerteten spektralen Restwerten unter Verwendung der Prädiktionskoeffizienten, die in den Seiteninformationen vorhanden sind, um die bewerteten Spektralwerte (X_{b}) zu erhalten;
inverses Bewerten der bewerteten Spektralwerte (X_{b}) und der zweiten Spektralwerte (X_{2cd}), um die ersten Spektralwerte (X₁) zu erhalten; und
Rücktransformieren der ersten Spektralwerte (X₁) in den Zeitbereich, um erste Zeitsignale (x₁) zu erhalten.

4. Verfahren zum Decodieren eines Bitstroms, der ein Audiosignal darstellt, wobei der Bitstrom gemäß einem ersten Codieralgorithmus codierte Signale, gemäß einem zweiten Codieralgorithmus codierte Signale und Seiteninformationen aufweist, wobei die gemäß dem zweiten Codieralgorithmus codierten Signale codierte spektrale Restwerte aufweisen, wobei die spektralen Restwerte durch Prädiktion über der Frequenz aus bewerteten Spektralwerten erzeugt sind, wobei Prädiktionskoeffizienten der Prädiktion in den Seiteninformationen vorhanden sind, mit folgenden Schritten:
Decodieren der gemäß dem ersten Codieralgorithmus codierten Signale (x_{2c}), um codierte, decodierte zweite Zeitsignale (x_{2cd}) zu erhalten, mittels des ersten Codieralgorithmus;
Decodieren der codierten spektralen Restwerte mittels des zweiten Codieralgorithmus, um die spektralen Restwerte zu erhalten;
Transformieren der codierten/decodierten zweiten Zeitsignale (x₂) in den Frequenzbereich, um die zweiten Spektralwerte (X_{2cd}) zu erhalten;
Durchführen einer Prädiktion mit den zweiten Spektralwerten (X_{2cd}) unter Verwendung der in den Seiteninformationen vorhandenen Prädiktionskoeffizienten, um zweite spektrale Restwerte zu erhalten;
inverses Bewerten der bewerteten spektralen Restwerte und der zweiten spektralen Restwerte, um die spektralen Restwerte zu erhalten;
Durchführen einer inversen Prädiktion mit den spektralen Restwerten unter Verwendung der in den Seiteninformationen gespeicherten Prädiktionskoeffizienten, um erste Spektralwerte (X₁) zu erhalten; und
Rücktransformieren der ersten Spektralwerte (X₁) in den Zeitbereich, um erste Zeitsignale (x₁) zu erhalten.

5. Vorrichtung (10) zum Codieren von diskreten, mit einer ersten Abtastrate abgetasteten ersten Zeitsignalen (x₁), mit folgenden Merkmalen:
einer Einrichtung (12) zum Erzeugen von zweiten Zeitsignalen (x₂), deren Bandbreite einer zweiten Abtastrate entspricht, aus den ersten Zeitsignalen (x₁), wobei die zweite Abtastrate gleich oder kleiner als die erste Abtastrate ist;
einer Einrichtung (14) zum Codieren der zweiten Zeitsignale (x₂) gemäß einem ersten Codieralgorithmus, um codierte zweite Signale (x_{2c}) zu erhalten;
einer Einrichtung (14) zum Decodieren der codierten zweiten Signale (x_{2c}) gemäß dem ersten Codieralgorithmus, um codierte/decodierte zweite Zeitsignale (x_{2cd}) zu erhalten, deren Bandbreite der zweiten Abtastfrequenz entspricht;
einer Einrichtung (24) zum Transformieren der ersten Zeitsignale (x₁) in den Frequenzbereich, um erste Spektralwerte (X₁) zu erhalten;
einer Einrichtung (25) zum Berechnen von Prädiktionskoeffizienten aus den ersten Spektralwerten (X₁);
einer Einrichtung (22, 23) zum Erzeugen von zweiten Spektralwerten (X_{2cd}) aus codierten/decodierten zweiten Zeitsignalen (x_{2cd}), wobei die zweiten Spektralwerte (X_{2cd}) eine Darstellung der codierten/decodierten zweiten Zeitsignale (x_{2cd}) im Frequenzbereich sind;
einer Einrichtung (26, 28) zum Bewerten der ersten Spektralwerte (X₁) mit den zweiten Spektralwerten (X_{2cd}), um bewertete Spektralwerte (X_{b}) zu erhalten, deren Anzahl der Anzahl der ersten Spektralwerte (X₁) entspricht;
einer Einrichtung (27) zum Durchführen einer Prädiktion der bewerteten Spektralwerte über der Frequenz mittels der berechneten Prädiktionskoeffizienten, um bewertete spektrale Restwerte zu erhalten; und
einer Einrichtung (30) zum Codieren der bewerteten spektralen Restwerte gemäß einem zweiten Codieralgorithmus, um codierte bewertete spektrale Restwerte zu erhalten.

6. Vorrichtung (10) zum Codieren von diskreten, mit einer ersten Abtastrate abgetasteten ersten Zeitsignalen (x₁), mit folgenden Merkmalen:
einer Einrichtung (12) zum Erzeugen von zweiten Zeitsignalen (x₂), deren Bandbreite einer zweiten Abtastrate entspricht, aus den ersten Zeitsignalen (x₁), wobei die zweite Abtastrate gleich oder kleiner als die erste Abtastrate ist;
einer Einrichtung (14) zum Codieren der zweiten Zeitsignale (x₂) gemäß einem ersten Codieralgorithmus, um codierte zweite Signale (x_{2c}) zu erhalten;
einer Einrichtung (14) zum Decodieren der codierten zweiten Signale (x_{2c}) gemäß dem ersten Codieralgorithmus, um codierte/decodierte zweite Zeitsignale (x_{2cd}) zu erhalten, deren Bandbreite der zweiten Abtastfrequenz entspricht;
einer Einrichtung (24) zum Transformieren der ersten Zeitsignale (x₁) in den Frequenzbereich, um erste Spektralwerte (X₁) zu erhalten;
einer Einrichtung (25) zum Berechnen von Prädiktionskoeffizienten aus den ersten Spektralwerten (X₁);
einer Einrichtung (22, 23) zum Erzeugen von zweiten Spektralwerten (X_{2cd}) aus codierten/decodierten zweiten Zeitsignalen (x_{2cd}), wobei die zweiten Spektralwerte (X_{2cd}) eine Darstellung der codierten/decodierten zweiten Zeitsignale (x_{2cd}) im Frequenzbereich sind;
einer Einrichtung (27, 27) zum Durchführen einer Prädiktion der ersten Spektralwerte (X₁) und der zweiten Spektralwerte (X_{2cd}) über der Frequenz, um erste spektrale Restwerte bzw. zweite spektrale Restwerte zu erhalten, unter Verwendung der berechneten Prädiktionskoeffizienten.
einer Einrichtung (26, 28) zum Bewerten der ersten spektralen Restwerte mit den zweiten spektralen Restwerten, um bewertete spektrale Restwerte zu erhalten, deren Anzahl der Anzahl der ersten Spektralwerte (X₁) entspricht; und
einer Einrichtung (30) zum Codieren der bewerteten spektralen Restwerte (X_{b}) gemäß einem zweiten Codieralgorithmus, um codierte bewertete spektrale Restwerte zu erhalten.

7. Vorrichtung zum Decodieren eines Bitstroms, der ein Audiosignal darstellt, wobei der Bitstrom gemäß einem ersten Codieralgorithmus codierte Signale, gemäß- einem zweiten Codieralgorithmus codierte Signale und Seiteninformationen aufweist, wobei die gemäß dem zweiten Codieralgorithmus codierten Signale codierte spektrale Restwerte aufweisen, wobei die spektralen Restwerte durch Prädiktion über der Frequenz aus bewerteten Spektralwerten erzeugt sind, wobei Prädiktionskoeffizienten der Prädiktion in den Seiteninformationen vorhanden sind, mit folgenden Merkmalen:
einer Einrichtung (50) zum Decodieren der gemäß dem ersten Codieralgorithmus codierten Signale (x_{2c}), um codierte, decodierte zweite Zeitsignale (x_{2cd}) zu er-halten, mittels des ersten Codieralgorithmus;
einer Einrichtung (54) zum Decodieren der codierten spektralen Restwerte mittels des zweiten Codieralgorithmus, um die spektralen Restwerte zu erhalten;
einer Einrichtung (64) zum Transformieren der codierten/decodierten zweiten Zeitsignale (x₂) in den Frequenzbereich, um die zweiten Spektralwerte (X_{2cd}) zu erhalten;
einer Einrichtung (59) zum Durchführen einer inversen Prädiktion mit den bewerteten spektralen Restwerten unter Verwendung der Prädiktionskoeffizienten, die in den Seiteninformationen vorhanden sind, um die bewerteten Spektralwerte (X_{b}) zu erhalten;
einer Einrichtung (60, 62) zum inversen Bewerten der bewerteten Spektralwerte (X_{b}) und der zweiten Spektralwerte (X_{2cd}), um die ersten Spektralwerte (X₁) zu erhalten; und
einer Einrichtung (66) zum Rücktransformieren der ersten Spektralwerte (X₁) in den Zeitbereich, um erste Zeitsignale (x₁) zu erhalten.

8. Vorrichtung zum Decodieren eines Bitstroms, der ein Audiosignal darstellt, wobei der Bitstrom gemäß einem ersten Codieralgorithmus codierte Signale, gemäß einem zweiten Codieralgorithmus codierte Signale und Seiteninformationen aufweist, wobei die gemäß dem zweiten Codieralgorithmus codierten Signale codierte spektrale Restwerte aufweisen, wobei die spektralen Restwerte durch Prädiktion über der Frequenz aus bewerteten Spektralwerten erzeugt sind, wobei Prädiktionskoeffizienten der Prädiktion in den Seiteninformationen vorhanden sind, mit folgenden Merkmalen:
einer Einrichtung (50) zum Decodieren der gemäß dem ersten Codieralgorithmus codierten Signale (x_{2c}), um codierte, decodierte zweite Zeitsignale (x_{2cd}) zu erhalten, mittels des ersten Codieralgorithmus;
einer Einrichtung (54) zum Decodieren der codierten spektralen Restwerte mittels des zweiten Codieralgorithmus, um die spektralen Restwerte zu erhalten;
einer Einrichtung (64) zum Transformieren der codierten/decodierten zweiten Zeitsignale (x₂) in den Frequenzbereich, die zweiten Spektralwerte (X_{2cd}) zu erhalten;
einer Einrichtung (27) zum Durchführen einer Prädiktion mit den zweiten Spektralwerten (X_{2cd}) unter Verwendung der in den Seiteninformationen vorhandenen Prädiktionskoeffizienten, um zweite spektrale Restwerte zu erhalten;
einer Einrichtung (60, 62) zum inversen Bewerten der bewerteten spektralen Restwerte und der zweiten spektralen Restwerte, um die spektralen Restwerte zu erhalten;
einer Einrichtung (59) zum Durchführen einer inversen Prädiktion mit den spektralen Restwerten unter Verwendung der in den Seiteninformationen gespeicherten Prädiktionskoeffizienten, um erste Spektralwerte (X₁) zu erhalten; und
einer Einrichtung (60) zum Rücktransformieren der ersten Spektralwerte (X₁) in den Zeitbereich, um erste Zeitsignale (x₁) zu erhalten.

## Claims

1. A method for coding discrete first time signals (x₁) which have been sampled with a first sampling rate, comprising the following steps:
generating second time signals (x₂), whose bandwidth corresponds to a second sampling rate, from the first time signals (x₁), the second sampling rate being equal to or less than the first sampling rate;
coding the second time signals (x₂) according to a first coding algorithm to obtain coded second signals (x_{2c}) ;
decoding the coded second signals (x_{2c}) according to the first coding algorithm to obtain coded/decoded second time signals (x_{2cd}) whose bandwidth corresponds to the second sampling frequency;
transforming the first time signals (x₁) into the frequency domain to obtain first spectral values (X₁);
calculating prediction coefficients from the first spectral values (X₁);
generating second spectral values (X_{2cd}) from coded/decoded second time signals (x_{2cd}), the second spectral values (X_{2cd}) being a representation of the coded/decoded second time signals (x_{2cd}) in the frequency domain;
evaluating the first spectral values (X₁) with the second spectral values (X_{2cd}) to obtain evaluated spectral values (X_{b}) whose number corresponds to the number of the first spectral values (X₁);
performing a prediction of the evaluated spectral values over the frequency by means of the calculated prediction coefficients to obtain evaluated residual spectral values; and
coding the evaluated residual spectral values according to a second coding algorithm to obtain coded evaluated residual spectral values.

2. A method for coding discrete first time signals (x₁) which have been sampled with a first sampling rate, comprising the following steps:
generating second time signals (x₂), whose bandwidth corresponds to a second sampling rate, from the first time signals (x₁), the second sampling rate being equal to or less than the first sampling rate;
coding the second time signals (x₂) according to a first coding algorithm to obtain coded second signals (x_{2c}) ;
decoding the coded second signals (x_{2c}) according to the first coding algorithm to obtain coded/decoded second time signals (x_{2cd}) whose bandwidth corresponds to the second sampling frequency;
transforming the first time signals (x₁) into the frequency domain to obtain first spectral values (X₁);
calculating prediction coefficients from the first spectral values (X₁) ;
generating second spectral values (X_{2cd}) from coded/decoded second time signals (x_{2cd}), the second spectral values (X_{2cd}) being a representation of the coded/decoded second time signals (x_{2cd}) in the frequency domain;
performing a prediction of the first spectral values (X1) and the second spectral values (X2Cd) over the frequency to obtain first residual spectral values and second residual spectral values, using the calculated prediction coefficients;
evaluating the first residual spectral values with the second residual spectral values to obtain evaluated residual spectral values whose number corresponds to the number of the first spectral values (X₁); and
coding the evaluated residual spectral values (X_{b}) according to a second coding algorithm to obtain coded evaluated residual spectral values.

3. A method for decoding a bit stream which represents an audio signal, where the bit stream has signals coded according to a first coding algorithm, signals coded according to a second coding algorithm, and side information, where the signals coded according to the second coding algorithm have coded residual spectral values, where the residual spectral values are generated from evaluated spectral values by prediction over the frequency, where prediction coefficients of the prediction are present in the side information, comprising the following steps:
decoding the coded signals (x_{2c}) which have been coded according to the first coding algorithm to obtain coded/decoded second time signals (x_{2cd}) by means of the first coding algorithm;
decoding the coded residual spectral values by means of the second coding algorithm to obtain the residual spectral values;
transforming the coded/decoded second time signals (x₂) into the frequency domain to obtain the second spectral values (X_{2cd}) ;
performing an inverse prediction with the evaluated residual spectral values using the prediction coefficients which are present in the side information to obtain the evaluated spectral values (X_{b}) ;
inversely evaluating the evaluated spectral values (X_{b}) and the second spectral values (X_{2cd}) to obtain the first spectral values (X₁) ; and
transforming the first spectral values (X₁) back into the time domain to obtain first time signals (x₁).

4. A method for decoding a bit stream which represents an audio signal, where the bit stream has signals coded according to a first coding algorithm, signals coded according to a second coding algorithm, and side information, where the signals coded according to the second coding algorithm have coded residual spectral values, where the residual spectral values are generated from evaluated spectral values by prediction over the frequency, where prediction coefficients of the prediction are present in the side information, comprising the following steps:
decoding the coded signals (x_{2c}) which have been coded according to the first coding algorithm to obtain coded/decoded second time signals (x_{2cd}) by means of the first coding algorithm;
decoding the coded residual spectral values by means of the second coding algorithm to obtain the residual spectral values;
transforming the coded/decoded second time signals (x₂) into the frequency domain to obtain the second spectral values (X_{2cd}) ;
performing a prediction with the second spectral values (X_{2cd}) using the prediction coefficients which are present in the side information to obtain second residual spectral values;
inversely evaluating the evaluated residual spectral values and the second residual spectral values to obtain the residual spectral values;
performing an inverse prediction with the residual spectral values using the prediction coefficients which are stored in the side information to obtain first spectral values (X₁) ; and
transforming the first spectral values (X₁) back into the time domain to obtain first time signals (x₁).

5. An apparatus (10) for coding discrete first time signals (x₁) which have been sampled with a first sampling rate, comprising the following features:
a device (12) for generating second time signals (x₂), whose bandwidth corresponds to a second sampling rate, from the first time signals (x₁), the second sampling rate being equal to or less than the first sampling rate;
a device (14) for coding the second time signals (x₂) according to a first coding algorithm to obtain coded second signals (x_{2c});
a device (14) for decoding the coded second signals (x_{2c}) according to the first coding algorithm to obtain coded/decoded second time signals (x_{2cd}) whose bandwidth corresponds to the second sampling frequency;
a device (24) for transforming the first time signals (x₁) into the frequency domain to obtain first spectral values (X₁);
a device (25) for calculating prediction coefficients from the first spectral values (X₁);
a device (22, 23) for generating second spectral values (X_{2cd}) from coded/decoded second time signals (x_{2cd}), the second spectral values (X_{2cd}) being a representation of the coded/decoded second time signals (x_{2cd}) in the frequency domain;
a device (26, 28) for evaluating the first spectral values (X₁) with the second spectral values (X_{2cd}) to obtain evaluated spectral values (X_{b}) whose number corresponds to the number of the first spectral values (X₁) ;
a device (27) for performing a prediction of the evaluated spectral values over the frequency by means of the calculated prediction coefficients to obtain evaluated residual spectral values; and
a device (30) for coding the evaluated residual spectral values according to a second coding algorithm to obtain coded evaluated residual spectral values.

6. An apparatus (10) for coding discrete first time signals (x₁) which have been sampled with a first sampling rate, comprising the following features:
a device (12) for generating second time signals (x₂), whose bandwidth corresponds to a second sampling rate, from the first time signals (x₁), the second sampling rate being equal to or less than the first sampling rate;
a device (14) for coding the second time signals (x₂) according to a first coding algorithm to obtain coded second signals (x_{2c}) ;
a device (14) for decoding the coded second signals (x_{2c}) according to the first coding algorithm to obtain coded/decoded second time signals (x_{2cd}) whose bandwidth corresponds to the second sampling frequency;
a device (24) for transforming the first time signals (x₁) into the frequency domain to obtain first spectral values (X₁);
a device (25) for calculating prediction coefficients from the first spectral values (X₁);
a device (22, 23) for generating second spectral values (X_{2cd}) from coded/decoded second time signals (x_{2cd}), the second spectral values (X_{2cd}) being a representation of the coded/decoded second time signals (x_{2cd}) in the frequency domain;
a device (27) for performing a prediction of the first spectral values (X₁) and the second spectral values (X_{2cd}) over the frequency to obtain first residual spectral values and second residual spectral values, using the calculated prediction coefficients;
a device (26, 28) for evaluating the first residual spectral values with the second residual spectral values to obtain evaluated residual spectral values whose number corresponds to the number of the first spectral values (X₁) ; and
a device (30) for coding the evaluated residual spectral values (X_{b}) according to a second coding algorithm to obtain coded evaluated residual spectral values.

7. An apparatus for decoding a bit stream which represents an audio signal, where the bit stream has signals coded according to a first coding algorithm, signals coded according to a second coding algorithm, and side information, where the signals coded according to the second coding algorithm have coded residual spectral values, where the residual spectral values are generated from evaluated spectral values by prediction over the frequency, where prediction coefficients of the prediction are present in the side information, comprising the following features:
a device (50) for decoding the coded signals (x_{2c}) which have been coded according to the first coding algorithm to obtain coded/decoded second time signals (x_{2cd}) by means of the first coding algorithm;
a device (54) for decoding the coded residual spectral values by means of the second coding algorithm to obtain the residual spectral values;
a device (64) for transforming the coded/decoded second time signals (x₂) into the frequency domain to obtain the second spectral values (X_{2cd});
a device (59) for performing an inverse prediction with the evaluated residual spectral values using the prediction coefficients which are present in the side information to obtain the evaluated spectral values (X_{b});
a device (60, 62) for inversely evaluating the evaluated spectral values (X_{b}) and the second spectral values (X_{2cd}) to obtain the first spectral values (X₁); and
a device (66) for transforming the first spectral values (X₁) back into the time domain to obtain first time signals (x₁).

8. An apparatus for decoding a bit stream which represents an audio signal, where the bit stream has signals coded according to a first coding algorithm, signals coded according to a second coding algorithm, and side information, where the signals coded according to the second coding algorithm have coded residual spectral values, where the residual spectral values are generated from evaluated spectral values by prediction over the frequency, where prediction coefficients of the prediction are present in the side information, comprising the following features:
a device (50) for decoding the coded signals (x_{2c}) which have been coded according to the first coding algorithm to obtain coded/decoded second time signals (x_{2cd}) by means of the first coding algorithm;
a device (54) for decoding the coded residual spectral values by means of the second coding algorithm to obtain the residual spectral values;
a device (64) for transforming the coded/decoded second time signals (x₂) into the frequency domain to obtain the second spectral values (X_{2cd}) ;
a device (27) for performing a prediction with the second spectral values (X_{2cd}) using the prediction coefficients which are present in the side information to obtain second residual spectral values;
a device (60, 62) for inversely evaluating the evaluated residual spectral values and the second residual spectral values to obtain the residual spectral values;
a device (59) for performing an inverse prediction with the residual spectral values using the prediction coefficients which are stored in the side information to obtain first spectral values (X₁) ; and
a device (60) for transforming the first spectral values (X₁) back into the time domain to obtain first time signals (x₁).

## Revendications

1. Procédé de codage de premiers signaux discrets dans le temps (x₁) balayés à une première vitesse de balayage, aux étapes suivantes consistant à :
générer, à partir des premiers signaux dans le temps (x₁), des seconds signaux dans le temps (x₂) dont la largeur de bande correspond à une seconde vitesse de balayage, la seconde vitesse de balayage étant égale ou inférieure à la première vitesse de balayage ;
coder les seconds signaux dans le temps (x₂) selon un premier algorithme de codage, pour obtenir des seconds signaux codés (x_{2c}) ;
décoder les seconds signaux codés (x_{2c}) selon le premier algorithme de codage, pour obtenir des seconds signaux dans le temps codés/décodés (x_{2cd}) dont la largeur de bande correspond à la seconde fréquence de balayage ;
transformer les premiers signaux dans le temps (x₁) à la plage de fréquence, pour obtenir des premières valeurs spectrales (X₁) ;
calculer des coefficients de prédiction à partir des premières valeurs spectrales (X₁) ;
générer des secondes valeurs spectrales (X_{2cd}) à partir de seconds signaux dans le temps codés/décodés (x_{2cd}), les secondes valeurs spectrales (X_{2cd}) étant une représentation des seconds signaux dans le temps codés/décodés (x_{2cd}) à la plage de fréquence ;
évaluer les premières valeurs spectrales (X₁) avec les secondes valeurs spectrales (X_{2cd}), pour obtenir des valeurs spectrales évaluées (X_{b}) dont le nombre correspond au nombre des premières valeurs spectrales (X₁) ;
effectuer une prédiction des valeurs spectrales évaluées sur la fréquence à l'aide des coefficients de prédiction calculés, pour obtenir des valeurs spectrales résiduelles évaluées ; et
coder les valeurs spectrales résiduelles évaluées selon un second algorithme de codage, pour obtenir des valeurs spectrales résiduelles évaluées codées.

2. Procédé de codage de premiers signaux discrets dans le temps (x₁) balayés à une première vitesse de balayage, aux étapes suivantes consistant à :
générer, à partir des premiers signaux dans le temps (x₁), des seconds signaux dans le temps (x₂) dont la largeur de bande correspond à une seconde vitesse de balayage, la seconde vitesse de balayage étant égale ou inférieure à la première vitesse de balayage ;
coder les seconds signaux dans le temps (x₂) selon un premier algorithme de codage, pour obtenir des seconds signaux codés (x_{2c});
décoder les seconds signaux codés (x_{2c}) selon le premier algorithme de codage, pour obtenir des seconds signaux dans le temps codés/décodés (x_{2cd}) dont la largeur de bande correspond à la seconde fréquence de balayage ;
transformer les premiers signaux dans le temps (x₁) à la plage de fréquence, pour obtenir des premières valeurs spectrales (X₁) ;
calculer des coefficients de prédiction à partir des premières valeurs spectrales (X₁) ;
générer des secondes valeurs spectrales (X_{2cd}) à partir de seconds signaux dans le temps codés/décodés (x_{2cd}), les secondes valeurs spectrales (X_{2cd}) étant une représentation des seconds signaux dans le temps codés/décodés (x_{2cd}) à la plage de fréquence ;
effectuer une prédiction des premières valeurs spectrales (X₁) et des secondes valeurs spectrales (X_{2cd}) sur la fréquence, pour obtenir des premières valeurs spectrales résiduelles ou des secondes valeurs spectrales résiduelles, en utilisant les coefficients de prédiction calculés ;
évaluer les premières valeurs spectrales résiduelles avec les secondes valeurs spectrales résiduelles, pour obtenir des valeurs spectrales résiduelles évaluées dont le nombre correspond au nombre des premières valeurs spectrales (X₁) ; et
coder les valeurs spectrales résiduelles évaluées (X_{b}) selon un second algorithme de codage, pour obtenir des valeurs spectrales résiduelles évaluées codées.

3. Procédé de décodage d'un courant de bits représentant un signal audio, le courant de bits présentant des signaux codés selon un premier algorithme de codage, des signaux codés selon un second algorithme de codage et des informations latérales, les signaux codés selon le second algorithme de codage présentant des valeurs spectrales résiduelles codées, les valeurs spectrales résiduelles étant générées à partir de valeurs spectrales évaluées, par prédiction sur la fréquence, les coefficients de prédiction de la prédiction étant présents dans les informations latérales, aux étapes suivantes consistant à :
décoder les signaux (x_{2c}) codés selon le premier algorithme de codage, pour obtenir des seconds signaux dans le temps codés décodés (x_{2cd}), à l'aide du premier algorithme de codage ;
décoder les valeurs spectrales résiduelles codées à l'aide du second algorithme de codage, pour obtenir les valeurs spectrales résiduelles ;
transformer les seconds signaux dans le temps codés/décodés (x₂) à la plage de fréquence, pour obtenir les secondes valeurs spectrales (X_{2cd}) ;
effectuer une prédiction inverse à l'aide des valeurs spectrales résiduelles évaluées, en utilisant les coefficients de prédiction présents dans les informations latérales, pour obtenir les valeurs spectrales évaluées (X_{b}) ;
évaluer inversement les valeurs spectrales évaluées (X_{b}) et les secondes valeurs spectrales (X_{2cd}), pour obtenir les premières valeurs spectrales (X₁) ; et
retransformer les premières valeurs spectrales (X₁) à la plage de temps, pour obtenir des premiers signaux dans le temps (x₁).

4. Procédé de décodage d'un courant de bits représentant un signal audio, le courant de bits présentant des signaux codés selon un premier algorithme de codage, des signaux codés selon un second algorithme de codage et des informations latérales, les signaux codés selon le second algorithme de codage présentant des valeurs spectrales résiduelles codées, les valeurs spectrales résiduelles étant générées à partir de valeurs spectrales évaluées, par prédiction sur la fréquence, les coefficients de prédiction de la prédiction étant présents dans les informations latérales, aux étapes suivantes consistant à :
décoder les signaux (x_{2c}) codés selon le premier algorithme de codage, pour obtenir des seconds signaux dans le temps codés décodés (x_{2cd}), à l'aide du premier algorithme de codage ;
décoder les valeurs spectrales résiduelles codées à l'aide du second algorithme de codage, pour obtenir les valeurs spectrales résiduelles ;
transformer les seconds signaux dans le temps codés/décodés (x₂) à la plage de fréquence, pour obtenir les secondes valeurs spectrales (X_{2cd}) ;
effectuer une prédiction à l'aide des secondes valeurs spectrales (X_{2cd}), en utilisant les coefficients de prédiction présents dans les informations latérales, pour obtenir des secondes valeurs spectrales résiduelles ;
évaluer inversement les valeurs spectrales résiduelles évaluées et les secondes valeurs spectrales résiduelles, pour obtenir les valeurs spectrales résiduelles ;
effectuer une prédiction inverse à l'aide des valeurs spectrales résiduelles, en utilisant les coefficients de prédiction mémorisés dans les informations latérales, pour obtenir des premières valeurs spectrales (X₁) ; et
retransformer les premières valeurs spectrales (X₁) à la plage de temps, pour obtenir des premiers signaux dans le temps (x₁).

5. Dispositif (10) de codage de premiers signaux discrets dans le temps (x₁) balayés à une première vitesse de balayage, aux caractéristiques suivantes :
un dispositif (12) destiné à générer, à partir des premiers signaux dans le temps (x₁), des seconds signaux dans le temps (x₂) dont la largeur de bande correspond à une seconde vitesse de balayage, la seconde vitesse de balayage étant égale ou inférieure à la première vitesse de balayage ;
un dispositif (14) destiné à coder les seconds signaux dans le temps (x₂) selon un premier algorithme de codage, pour obtenir des seconds signaux codés (x_{2c}) ;
un dispositif (14) destiné à décoder les seconds signaux codés (x_{2c}) selon le premier algorithme de codage, pour obtenir des seconds signaux dans le temps codés/décodés (x_{2cd}) dont la largeur de bande correspond à la seconde fréquence de balayage ;
un dispositif (24) destiné à transformer les premiers signaux dans le temps (x₁) à la plage de fréquence, pour obtenir des premières valeurs spectrales (X₁) ;
un dispositif (25) destiné à calculer des coefficients de prédiction à partir des premières valeurs spectrales (X₁) ;
un dispositif (22, 23) destiné à générer des secondes valeurs spectrales (X_{2cd}) à partir de seconds signaux dans le temps codés/décodés (x_{2cd}), les secondes valeurs spectrales (X_{2cd}) étant une représentation des seconds signaux dans le temps codés/décodés (x2cd) à la plage de fréquence ;
un dispositif (26, 28) destiné à évaluer les premières valeurs spectrales (X1) avec les secondes valeurs spectrales (X2cd), pour obtenir des valeurs spectrales évaluées (Xb) dont le nombre correspond au nombre des premières valeurs spectrales (X1);
un dispositif (27) destiné à effectuer une prédiction des valeurs spectrales évaluées sur la fréquence à l'aide des coefficients de prédiction calculés, pour obtenir des valeurs spectrales résiduelles évaluées ; et
un dispositif (30) destiné à coder les valeurs spectrales résiduelles évaluées selon un second algorithme de codage, pour obtenir des valeurs spectrales résiduelles évaluées codées.

6. Dispositif (10) de codage de premiers signaux discrets dans le temps (x₁) balayés à une première vitesse de balayage, aux caractéristiques suivantes :
un dispositif (12) destiné à générer, à partir des premiers signaux dans le temps (x₁), des seconds signaux dans le temps (x₂) dont la largeur de bande correspond à une seconde vitesse de balayage, la seconde vitesse de balayage étant égale ou inférieure à la première vitesse de balayage ;
un dispositif (14) destiné à coder les seconds signaux dans le temps (x₂) selon un premier algorithme de codage, pour obtenir des seconds signaux codés (X_{2c}) ;
un dispositif (14) destiné à décoder les seconds signaux codés (x_{2c}) selon le premier algorithme de codage, pour obtenir des seconds signaux dans le temps codés/décodés (x_{2cd}) dont la largeur de bande correspond à la seconde fréquence de balayage ;
un dispositif (24) destiné à transformer les premiers signaux dans le temps (x₁) à la plage de fréquence, pour obtenir des premières valeurs spectrales (X₁) ;
un dispositif (25) destiné à calculer des coefficients de prédiction à partir des premières valeurs spectrales (X₁) ;
un dispositif (22, 23) destiné à générer des secondes valeurs spectrales (X_{2cd}) à partir de seconds signaux dans le temps codés/décodés (x_{2cd}), les secondes valeurs spectrales (X_{2cd}) étant une représentation des seconds signaux dans le temps codés/décodés (x_{2cd}) à la plage de fréquence ;
un dispositif (27, 27) destiné à effectuer une prédiction des premières valeurs spectrales (X₁) et des secondes valeurs spectrales (X_{2cd}) sur la fréquence, pour obtenir des premières valeurs spectrales résiduelles ou des secondes valeurs spectrales résiduelles, en utilisant les coefficients de prédiction calculés ;
un dispositif (26, 28) destiné à évaluer les premières valeurs spectrales résiduelles avec les secondes valeurs spectrales résiduelles, pour obtenir des valeurs spectrales résiduelles évaluées dont le nombre correspond au nombre des premières valeurs spectrales (X₁) ; et
un dispositif (30) destiné à coder les valeurs spectrales résiduelles évaluées (X_{b}) selon un second algorithme de codage, pour obtenir des valeurs spectrales résiduelles évaluées codées.

7. Dispositif de décodage d'un courant de bits représentant un signal audio, le courant de bits présentant des signaux codés selon un premier algorithme de codage, des signaux codés selon un second algorithme de codage et des informations latérales, les signaux codés selon le second algorithme de codage présentant des valeurs spectrales résiduelles codées, les valeurs spectrales résiduelles étant générées à partir de valeurs spectrales évaluées, par prédiction sur la fréquence, les coefficients de prédiction de la prédiction étant présents dans les informations latérales, aux caractéristiques suivantes :
un dispositif (50) destiné à décoder les signaux (x_{2c}) codés selon le premier algorithme de codage, pour obtenir des seconds signaux dans le temps codés décodés (x_{2cd}), à l'aide du premier algorithme de codage ;
un dispositif (54) destiné à décoder les valeurs spectrales résiduelles codées à l'aide du second algorithme de codage, pour obtenir les valeurs spectrales résiduelles ;
un dispositif (64) destiné à transformer les seconds signaux dans le temps codés/décodés (x₂) à la plage de fréquence, pour obtenir les secondes valeurs spectrales (X_{2cd}) ;
un dispositif (59) destiné à effectuer une prédiction inverse à l'aide des valeurs spectrales résiduelles évaluées, en utilisant les coefficients de prédiction présents dans les informations latérales, pour obtenir les valeurs spectrales évaluées (X_{b}) ;
un dispositif (60, 62) destiné à évaluer inversement les valeurs spectrales évaluées (X_{b}) et les secondes valeurs spectrales (X_{2cd}), pour obtenir les premières valeurs spectrales (X₁) ; et
un dispositif (66) destiné à retransformer les premières valeurs spectrales (X₁) à la plage de temps, pour obtenir des premiers signaux dans le temps (x₁).

8. Dispositif de décodage d'un courant de bits représentant un signal audio, le courant de bits présentant des signaux codés selon un premier algorithme de codage, des signaux codés selon un second algorithme de codage et des informations latérales, les signaux codés selon le second algorithme de codage présentant des valeurs spectrales résiduelles codées, les valeurs spectrales résiduelles étant générées à partir de valeurs spectrales évaluées, par prédiction sur la fréquence, les coefficients de prédiction de la prédiction étant présents dans les informations latérales, aux caractéristiques suivantes :
un dispositif (50) destiné à décoder les signaux (x_{2c}) codés selon le premier algorithme de codage, pour obtenir des seconds signaux dans le temps codés décodés (x_{2cd}), à l'aide du premier algorithme de codage ;
un dispositif (54) destiné à décoder les valeurs spectrales résiduelles codées à l'aide du second algorithme de codage, pour obtenir les valeurs spectrales résiduelles ;
un dispositif (64) destiné à transformer les seconds signaux dans le temps codés/décodés (x₂) à la plage de fréquence, pour obtenir les secondes valeurs spectrales (X_{2cd}) ;
un dispositif (27) destiné à effectuer une prédiction à l'aide des secondes valeurs spectrales (X_{2cd}), en utilisant les coefficients de prédiction présents dans les informations latérales, pour obtenir des secondes valeurs spectrales résiduelles ;
un dispositif (60, 62) destiné à évaluer inversement les valeurs spectrales résiduelles évaluées et les secondes valeurs spectrales résiduelles, pour obtenir les valeurs spectrales résiduelles ;
un dispositif (59) destiné à effectuer une prédiction inverse à l'aide des valeurs spectrales résiduelles, en utilisant les coefficients de prédiction mémorisés dans les informations latérales, pour obtenir des premières valeurs spectrales (X₁) ; et
un dispositif (60) destiné à retransformer les premières valeurs spectrales (X₁) à la plage de temps, pour obtenir des premiers signaux dans le temps (x₁).
